# EUROPEAN PATENT SPECIFICATION

(11) **EP 1 107 333 B1**
(45) Date of publication and mention of the grant of the patent: **25.07.2007**
(21) Application number: 00126999.2
(22) Date of filing: 08.12.2000
(51) Int. Cl.: H01L 51/42, H01G 9/20

(54) **Photoelectric conversion device and method of production**
Photoelektrische Umwandlungsvorrichtung und Herstellungsverfahren
Dispositif de conversion photoélectrique et procédé de fabrication

(30) Priority: 10.12.1999 JP 35183899; 29.08.2000 JP 2000259216
(43) Date of publication of application: 13.06.2001
(73) Proprietor: FUJIFILM Corporation, Minato-ku Tokyo (JP)
(72) Inventor: Tsukahara, Jiro, Minami-Ashigara-shi, Kanagawa-ken 258 (JP); Shiratsuchi, Kentaro, Minami-Ashigara-shi, Kanagawa-ken 258 (JP); Kubota, Tadahiko, Minami-Ashigara-shi, Kanagawa-ken 258 (JP); Sen, Syoichi, Minami-Ashigara-shi, Kanagawa-ken 258 (JP)
(74) Representative: Grünecker, Kinkeldey, Stockmair & Schwanhäusser Anwaltssozietät

(56) References cited:
- EP-A- 0 901 175
- O'REGAN B ET AL: "EFFICIENT PHOTO-HOLE INJECTION FROM CYANINE DYES INTO CUSCN: A PROSPECTIVE P-TYPE MATERIAL FOR A DYE SENSITIZED P-N HETEROJUNCTION" PROCEEDINGS OF THE ELECTROCHEMICAL SOCIETY, NEW YORK,NY, US, vol. 95, no. 8, 1995, pages 208-221, XP000922692
- BACH U ET AL: "SOLID-STATE DYE-SENSITIZED MESOPOROUS TIO2 SOLAR CELLS WITH HIGH PHOTON-TO-ELECTRON CONVERSION EFFICIENCIES" NATURE, MACMILLAN JOURNALS LTD. LONDON, GB, vol. 395, 8 October 1998 (1998-10-08), pages 583-585, XP000783901 ISSN: 0028-0836
- PAPAGEORGIOU N ET AL: "The Performance and Stability of Ambient Temperature Molten Salts for Solar Cell Applications" JOURNAL OF THE ELECTROCHEMICAL SOCIETY, ELECTROCHEMICAL SOCIETY. MANCHESTER, NEW HAMPSHIRE, US, vol. 143, no. 10, October 1996 (1996-10), pages 3099-3108, XP002118482 ISSN: 0013-4651

## Description

### FIELD OF THE INVENTION

The present invention relates to a dye-sensitized photoelectric conversion device and a photoelectric cell using the same. In particular, the invention relates to a photoelectric conversion device using fine semiconductor particles sensitized with a dye, and a photoelectric cell using the same.

### BACKGROUND OF THE INVENTION

As to solar electric power generation, mono-crystalline silicon solar cells, polycrystalline silicon solar cells, amorphous silicon cells and solar cells of compounds such as cadmium telluride and copper indium selenide have come in practice, and research and development have been mainly conducted on them. However, for popularizing them, it is necessary to overcome the problems of production cost, ensuring of raw materials and long energy payback time. On the other hand, many solar cells using organic materials directed to enlargement in area and reduction in cost have hitherto been proposed. However, they have the problems of low conversion efficiency and poor durability.

Under such conditions, Nature, 353, 737-740 (1991) and U.S. Patent 4,927,721 disclosed photoelectric conversion devices using fine semiconductor particles sensitized with dyes and photoelectric cells using the devices, and materials and techniques for manufacturing them. The cells proposed are wet type solar cells in which porous titanium dioxide films spectrally sensitized with ruthenium complexes are used as working electrodes. The first advantage of this system is that inexpensive oxide semiconductors such as titanium dioxide can be used without their purification to high purity, which makes it possible to provide inexpensive photoelectric conversion devices. The second advantage is that light can be converted to electricity in the wavelength region of almost all visible light rays, because of broad absorption of the dyes used. However, these devices are for wet type solar cells in which the devices are electrically connected to counter electrodes with electrolytic solutions, so that the long-term use thereof causes the fear of significant reduction in photoelectric characteristics by exhaustion of the electrolytic solutions, resulting in failure to function as the devices.

To solve the problem of exhaustion of the electrolytic solution with time in the wet type solar cells, J. Phys. D: Appl. Phys., 1492-1496 (1998) has proposed a solid photoelectric conversion device in which CuI is used as a hole transfer material. As a result of a study, it has become clear that the solid photoelectric conversion.device using this hole transfer material has the problem of significantly deteriorating in photoelectric characteristics such as short-circuit current density (Jsc) for a few days.

O'REGAN B.ET AL.,"EFFICIENT PHOTO-HOLE INJECTION FROM CYANINE DYES INTO CuSCN: A PROSPECTIVE p-TYPE MATERIAL FOR A DYE-SENSITIZED p-n HETEROJUNCTION", PROCEEDINGS OF THE ELECTROCHEMICAL SOCIETY, NEW YORK, NY, US, vol. 95, no. 8, 1995, pages 208-221, discloses a dye-sensitized photoelectric Conversion device comprising a p-type semiconductor and a thiocyanate.

### SUMMARY OF THE INVENITON

An object of the invention is to provide a dye-sensitized photoelectric conversion device having excellent photoelectric characteristics and durability.

Other objects and effects of the present invention will become apparent from the following description.

The objects of the invention have been achieved by providing the following photoelectric conversion device, photoelectric cell, solar cell module, and method for manufacturing a photoelectric conversion device.

A dye-sensitized photoelectric conversion device comprising a conductive layer, a photosensitive layer, a charge transfer layer and a counter electrode, wherein said charge transfer layer comprises a p-type inorganic compound semiconductor and a thiocyanate, said thiocyanate being a molten salt.

A photoelectric cell using the above photoelectric conversion device.

A solar cell module using the above photoelectric conversion device.

A method for manufacturing a dye-sensitized photoelectric conversion device comprising a conductive layer, a photosensitive layer, a charge transfer layer and a counter electrode, which comprises:
forming, on the photosensitive layer, a first layer containing a p-type inorganic compound semiconductor and a thiocyanate, said thiocyanate being a molten salt.

Preferred embodiments of the invention are set forth in the sub-claims.

### BRIEF DESCRIPTION OF THE DRAWINGS

Fig. 1 is a partial sectional view showing a structure of a preferred photoelectric conversion device of the invention;
Fig. 2 is a partial sectional view showing a structure of a preferred photoelectric conversion device of the invention;
Fig. 3 is a partial sectional view showing a structure of a preferred photoelectric conversion device of the invention;
Fig. 4 is a partial sectional view showing a structure of a preferred photoelectric conversion device of the invention;
Fig. 5 is a partial sectional view showing a structure of a preferred photoelectric conversion device of the invention ;
Fig. 6 is a partial sectional view showing a structure of a preferred photoelectric conversion device of the invention;
Fig. 7 is a partial sectional view showing a structure of a preferred photoelectric conversion device of the invention;
Fig. 8 is a partial sectional view showing a structure of a preferred photoelectric conversion device of the invention;
Fig. 9 is a partial sectional view showing a structure of a preferred photoelectric conversion device of the invention; and
Fig. 10 is a partial sectional view showing a structure of a preferred solar cell module of the invention.

### DETAILED DESCRIPTION OF THE INVENTION

### 1. Photoelectric conversion device

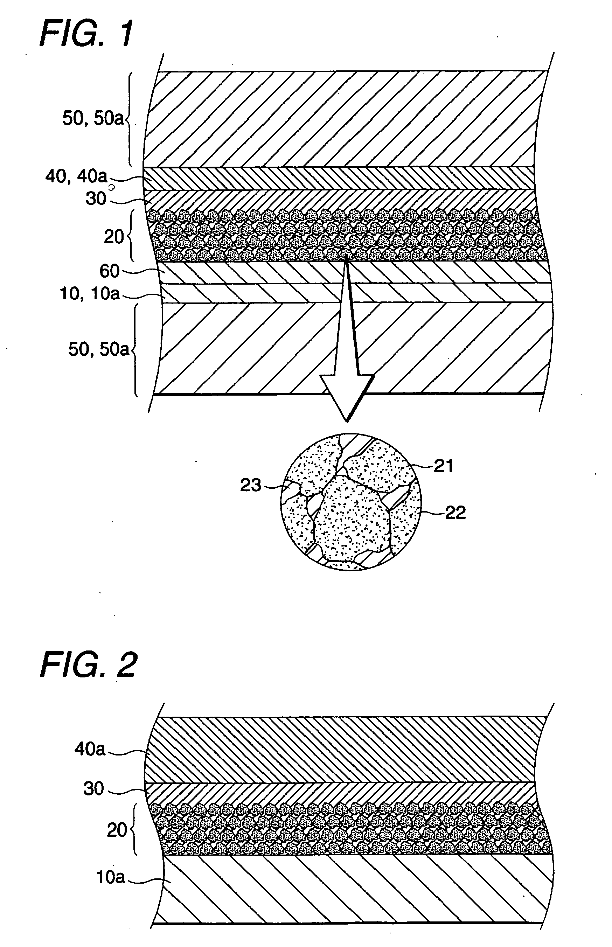

The photoelectric conversion device of the invention has a feature that the charge transfer layer comprises a p-type inorganic compound semiconductor and a thiocyanate. Preferably, a conductive layer 10, an undercoat layer 60, a photosensitive layer 20, a charge transfer layer 30 and a counter electrode conductive layer 40 are laminated in this order, and the photosensitive layer is constituted by fine semiconductor particles 21 sensitized with a dye 22 and a charge transfer material 23 allowed to penetrate into spaces between the fine semiconductor particles 21, as shown in Fig. 1. The charge transfer material 23 comprises the same components as those of the charge transfer layer 30. For reinforcing the photoelectric conversion device, the device may be provided with a substrate 50 as an undercoat for the conductive layer 10 and/or the counter electrode layer 40. In the invention, a layer comprising the conductive layer 10 and the optional substrate 50 is hereinafter referred to as a "conductive support", and a layer comprising the counter conductive layer 40 and the substrate 50 as a "counter electrode". The conductive layer 10, the counter electrode conductive layer 40 and the substrate 50 shown in Fig. 1 may be a transparent conductive layer 10a, a transparent counter electrode conductive layer 40a and a transparent substrate 50a, respectively. Manufactured for connecting the photoelectric conversion device to an external load to do electric work (electric power generation) is the photoelectric cell, and manufactured for sensing optical information is a photosensor. Of the photoelectric cells, one mainly aiming at solar electric power generation is called a solar cell.

When the fine semiconductor particles are of the n-type in the photoelectric conversion device of the invention shown in Fig. 1, light incident on the photosensitive layer 20 containing the fine semiconductor particles 21 sensitized with the dye 22 excites the dye 22 and so on. High-energy electrons in the dye 22 and so on excited are transferred to conduction bands of the fine semiconductor particles 21, and further arrive at the conductive layer 10 by diffusion. At this time, molecules of the dye 22 and so on have been turned to oxides. In the photoelectric cell, the electrons in the conductive layer 10 return to the oxides of the dye 22 and so on via the counter conductive layer 40 and the charge transfer layer 30 while doing work in an external circuit, thereby reproducing the dye 22. The photosensitive layer 20 acts as a negative electrode (light anode), and the counter electrode 40 acts as a positive electrode. At boundaries between the respective layers (for example, at a boundary between the conductive layer 10 and the photosensitive layer 20, a boundary between the photosensitive layer 20 and the charge transfer layer 30 and a boundary between the charge transfer layer 30 and the counter electrode conductive layer 40), constituents of the respective layers may be mixed with each other by diffusion. The respective layers will be described in detail below.

### (A) Conductive Support:

The conductive support may be (1) a single conductive layer, or may comprise (2) two layers of a conductive layer and a substrate. In the case of (1), materials keeping sufficient strength and sealing properties are used as the conductive layers. For example, metal materials (platinum, gold, silver, copper, zinc, titanium, aluminum and alloys containing them) can be used. In the case of (2), the substrates having the conductive agent-containing conductive layers can be used on the photosensitive layer side. Preferred examples of the conductive agents include metals (for example, platinum, gold, silver, copper, zinc, titanium, aluminum, indium and alloys containing them), carbon and conductive metal oxides (for example, indium-tin complex oxide and tin oxide doped with fluorine or antimony). The thickness of the conductive layers is preferably from 0.02 µm to 10 µm.

It is preferred that the conductive layers are lower in surface resistance. The surface resistance is preferably 50 Ω/square or less, and more preferably 20 Ω/square or less.

When light is irradiated from the conductive support side, it is preferred that the conductive supports are substantially transparent. The term "substantially transparent" means that the transmittance is 10% or more at a part or the whole of the visible to near-infrared light region (400 nm to 1200 nm), preferably 50% or more, and more preferably 80% or more. In particular, it is preferred that the transmittance is high at a wavelength region at which the photosensitive layer has sensitivity.

As the transparent conductive support, preferred is a support in which a transparent conductive layer comprising a conductive metal oxide is formed on the surface of a transparent glass or plastic substrate by coating or vapor deposition. Preferred examples of the transparent conductive layers include tin dioxide doped with fluorine or antimony and indium-tin oxide (ITO). The transparent substrates which can be used include transparent polymer films, as well as glass substrates such as soda glass substrates advantageous in terms of low cost and strength and no-alkali glass substrates unaffected by alkali elution. Materials for the transparent polymer films include triacetyl cellulose (TAC), polyethylene terephthalate (PET), polyethylene naphthalate (PEN), syndiotactic polystyrene (SPS), polyphenylene sulfide (PPS), polycarbonates (PCs), polyarylate (PAr), polysulfones (PSFs), polyestersulfones (PESs), polyimides (PIs), polyetherimides (PEIs), cyclic polyolefins and bromated phenoxy compounds. For securing sufficient transparency, the amount of the conductive metal oxide coated is preferably from 0.01 g to 100 g per m² of glass or plastic support.

For decreasing the resistance of the transparent conductive support, a metal lead is preferably used. Materials for the metal leads are preferably metals such as platinum, gold, nickel, titanium, aluminum, copper and silver. It is preferred that the metal lead is attached to the transparent substrate by sputtering or vapor deposition and the transparent conductive layer comprising a conductive tin oxide or ITO film is formed thereon. The reduction in the amount of incident light caused by the attachment of the metal leads is preferably 10% or less, and more preferably from 1% to 5%.

### (B) Photosensitive layer:

In the photosensitive layer, the semiconductor acts as a light-sensitive material, and absorbs light to conduct charge separation, thereby generating electrons and holes. In the dye-sensitized semiconductor, the light absorption and the generation of electrons and holes thereby mainly occur in the dyes, and the fine semiconductor particles have the function of receiving and transferring the electrons (or holes). The semiconductor for use in the invention is preferably an n-type semiconductor in which the conduction electrons act as carriers under light excitation to give anode current.

### (B-1) Semiconductor:

The semiconductor that can be used includes element semiconductors such as silicon and germanium, semiconductors of the group III-V family, metal chalcogenides (for example, oxides, sulfides, selenides and complexes thereof) and compounds having the perovskite structure (for example, strontium titanate, calcium titanate, sodium titanate, barium titanate and potassium niobate).

Preferred examples of the metal chalcogenide include oxides of titanium, tin, zinc, iron, tungsten, zirconium, hafnium, strontium, indium, cerium, yttrium, lanthanum, vanadium, niobium and tantalum, sulfides of cadmium, zinc, lead, silver, antimony and bismuth, selenides of cadmium and lead, and cadmium telluride. The other compound semiconductors include phosphides of zinc, gallium, indium and cadmium, selenides of gallium-arsenic and copper-indium, and copper-indium sulfide. Further, complexes such as MxOySz and M₁xM₂yOz (M, M₁ and M₂ each represents a metal element, O represents oxygen, and x, y and z are combined in number so as to give a neutral valence) can also be preferably used.

Preferred specific examples of the semiconductor for use in the invention are Si, TiO₂, SnO₂, Fe₂O₃, WO₃, ZnO, Nb₂O₅, CdS, ZnS, PbS, Bi₂S₃, CdSe, CdTe, SrTiO₃, GaP, InP, GaAs, CuInS₂ and CuInSe₂. More preferred examples thereof are TiO₂, ZnO, SnO₂, Fe₂O₃, WO₃, Nb₂O₅, CdS, PbS, CdSe, CdTe, SrTiO₃, InP, GaAs, CuInS₂ and CuInSe₂, and particularly preferred examples thereof are TiO₂ and Nb₂O₅. Most preferred example thereof is TiO₂. TiO₂ is preferably TiO₂ containing 70% or more of anatase type crystals, and particularly preferably TiO₂ containing 100% of anatase type crystals.

Although the semiconductor for use in the invention may be either mono-crystalline or polycrystalline, they are preferably polycrystalline from the viewpoints of production cost, ensuring of raw materials and energy payback time, and particularly preferably of porous films comprising the fine semiconductor particles. They may partly contain amorphous portions.

Although the size of the fine semiconductor particles is generally on an order of from "nm" to "µm", the average size of primary particles determined from a diameter of a circle to which a projected area is converted is preferably from 5 nm to 200 nm, and more preferably from 8 nm to 100 nm. The average size of the fine semiconductor particles in a dispersion solution (secondary particles) is preferably from 0.01 µm to 30 µm. Two or more kinds of fine particles different in particle size distribution may be mixed. In this case, the average size of the smaller particles is preferably 25 nm or less, and more preferably 10 nm or less. For scattering incident light to improve the capture rate, it is also preferred that semiconductor particles having a large size, for example, a size of from about 100 nm to about 300 nm, are mixed.

Two or more kinds of fine semiconductor particles may be mixed. When two or more kinds of fine semiconductor particles are used as a mixture, one is preferably TiO₂, ZnO, Nb₂O₅ or SrTiO₃, and the other is preferably SnO₂, Fe₂O₃ or WO₃. More preferred examples of the combinations include a combination of ZnO and SnO₂, a combination of ZnO and WO₃, and a combination of ZnO, SnO₂ and WO₃. When two or more kinds of fine semiconductor particles are used as a mixture, the respective kinds of particles may be different from each other in size. In particular, a combination of the first kind of fine semiconductor particles having a large particle size and the second and subsequent kinds of fine semiconductor particles having a small size is preferred. Preferably, the large-sized particles have a size of 100 nm or more, and the small-sized particles have a size of 15 nm or less.

As methods for preparing the fine semiconductor particles, preferred are sol-gel methods described in Sumio Sakubana, "Science of Sol-Gel Methods", Agune Shofusha (1998) and Gijutsu Joho Kyokai, "Film Coating Techniques by Sol-Gel Methods" (1995), and gel-sol methods described in Tadao Sugimoto, "Synthesis of Monodisperse Particles by New Synthesis Methods, Gel-Sol Methods, and Size Form Control" and Materia, 35 (9), 1012-1018 (1996). A method developed by Degussa is also preferred in which a chloride is hydrolyzed in an oxyhydrogen salt at high temperature to prepare an oxide.

When the fine semiconductor particles are composed of titanium oxide, all of the above-mentioned sol-gel methods, gel-sol methods and high-temperature hydrolysis of the chloride in the oxyhydrogen salt are preferred. However, a sulfuric acid method and a chlorine method described in Manabu Seino, "Titanium Oxide, Material Properties and Application Techniques", Gihodo Shuppan (1997) can also be used. Further, as the sol-gel methods, a method described in Barbe et al., Journal of American Ceramic Society, 80 (12) 3157-3171 (1997) and a method described in Burnside et a., Chemistry of Materials, 10 (9), 2419-2425 are also preferred.

### (B-2) Fine Semiconductor Particle Layer:

For coating the conductive support with the fine semiconductor particles, the above-mentioned sol-gel methods can also be used, as well as a method of coating the conductive support with a dispersion or colloidal solution of the fine semiconductor particles. Considering the quality production of the photoelectric conversion devices, the material properties of the fine semiconductor particle solutions and the adaptability of the conductive supports, wet film formation methods are relatively advantageous. Typical examples of the wet film formation methods include coating, printing, electrolytic precipitation and electrodeposition. A method of oxidizing a metal, a method of precipitating in a liquid phase from a metal solution by ligand exchange (LPD method), a vapor deposition method by sputtering, a CVD method or an SPD method of spraying a heat-decomposable metal oxide precursor onto a heated substrate to form a metal oxide can also be utilized.

Methods for preparing the dispersions of the fine semiconductor particles include a method of grinding the particles in a mortar, a method of dispersing the particles with pulverizing in a mill, and a method of precipitating a semiconductor as fine particles in a solvent in synthesizing the semiconductor and using them as such, as well as the above-mentioned sol-gel methods.

The dispersing media include water and various kinds of organic solvents (for example, methanol, ethanol, isopropyl alcohol, citronellol, terpineol, dichloromethane, acetone, acetonitrile and ethyl acetate). In dispersing the particles, for example, polymers such as polyethylene glycol, hydroxyethyl cellulose and carboxymethyl cellulose, surfactants, acids or chelating agents may be used as dispersing aids. It becomes possible to control the viscosity of the dispersions by changing the molecular weight of polyethylene glycol, thereby being able to form semiconductor layers difficult to be separated, or to control the porosity of the semiconductor layers. Accordingly, addition of polyethylene glycol is preferred.

Preferred examples of the coating method include a roller method and a dip method as the application system, an air knife method and a blade method as the metering system, and a wire bar method described in JP-B-58-4589 (the term "JP-B" as used herein means an "examined Japanese patent publication") and a slide hopper method, an extrusion method and a curtain method described in U.S. Patents 2,681,294, 2,761,419 and 2,761,791. Further, a spin method or a spray method is also preferred as a general-purpose method. Preferred examples of wet printing methods include intaglio printing, rubber plate printing and screen printing, as well as the three typical printing methods of relief printing, offset printing and gravure printing. A preferred film formation method is selected from these methods, depending on the solution viscosity or the wet thickness.

Not only the fine semiconductor particles can be applied in a single layer, but also dispersions of the fine semiconductor particles different in particle size or dispersions containing the fine semiconductor particles different in kind (or binders or additives different in kind) can be applied in multiple layers. When the film thickness is insufficient in one coating, coating in multiple layers is also effective.

In general, the amount of a dye carried per unit projected area increases with an increase in thickness of the fine semiconductor layer (the same as the thickness of the photosensitive layer), so that the capture rate of light becomes high. However, the diffusion distance of electrons generated increases, which increases a loss caused by charge recombination. Accordingly, the thickness of the fine semiconductor particle layer is preferably from 0.1 µm to 100 µm. When the fine semiconductor particle layers are used in the photoelectric cells, the thickness thereof is preferably from 1 µm to 30 µm, and more preferably from 2 µm to 25 µm. The amount of the fine semiconductor particles coated per square meter of support is preferably from 0.5 g to 100 g, and more preferably from 3 g to 50 g.

After the conductive support is coated with the fine semiconductor particles, heat treatment is preferably conducted for bringing the fine semiconductor particles into electrical contact with one another and improving the strength of coating or the adhesion of coating with the support. The preferred range of the heating temperature is preferably from 40°C to 700°C, and more preferably from 100°C to 600°C. The heating time is from about 10 minutes to about 10 hours. When the support low in melting point or softening point such as a polymer film is used, high-temperature treatment unfavorably causes deterioration of the support. Also from the viewpoint of cost, the heat treatment is preferably conducted at as low temperatures as possible (for example, from 50°C to 350°C). The heat treatment at low temperatures become possible by heating in the presence of fine semiconductor particles having a small size of 5 nm or less, mineral acids or metal oxide precursors. It also becomes possible by irradiation of ultraviolet rays, infrared rays or microwaves, or application of electric fields or ultrasonic waves. For removing unnecessary organic substances at the same time, it is preferred that heating, pressure reduction, oxygen plasma treatment, pure water washing, solvent washing and gas washing are used appropriately in combination, in addition to the above-mentioned irradiation and application.

After the heat treatment, for increasing the surface area of the fine semiconductor particles or raising the purity of the vicinities of the fine semiconductor particles to increase the injection efficiency of electrons from the dye to the fine semiconductor particles, for example, chemical plating treatment using an aqueous solution of titanium tetrachloride or electrochemical plating treatment using an aqueous solution of titanium trichloride may be conducted.

It is preferred that the fine semiconductor particle layer has large surface area so that it can absorb the dye in large amounts. The surface area in a state in which the support is coated with the fine semiconductor particles is preferably 10 times or more, and more preferably 100 times or more the projected area. Although there is no particular limitation on the upper limit thereof, it is usually about 1000 times.

### (B-3) Dye:

The sensitizing dye for use in the photosensitive layers may be any, as long as they have absorption in the visible ray region or the near infrared ray region, and are compounds that can sensitize the semiconductors. However, organic metal complex dyes, methine dyes, porphyrin dyes and phthalocyanine dyes are preferred. For making the wavelength region of photoelectric conversion as wide as possible and increasing the conversion efficiency, two or more kinds of dyes can be used in combination or mixed. In this case, the dyes to be used in combination or mixed and the ratio thereof can be selected to the intended wavelength region of a light source and strength distribution.

It is preferred that such dyes have appropriate interlocking groups having adsorption ability to surfaces of the fine semiconductor particles. Preferred examples of the interlocking groups include acidic groups such as COOH, OH, SO₃H, -P(O)(OH)₂ and -OP(O)(OH)₂ groups, and chelating groups having n conductivity such as oximes, dioximes, hydroxyquinoline, salicylates and ketoenolates. The COOH, -P(O)(OH)₂ and -OP(O)(OH)₂ groups are particularly preferred among others. These groups may form either salts with alkali metals or internal salts. When polymethine dyes contain acidic groups, for example, when methine chains form squalirium rings or croconium rings, these moieties may be utilized as the interlocking groups.

Preferred examples of the sensitizing dyes used in the photosensitive layers will be specifically described below.

### (a) Organic Metal Complex Dye:

When the dyes are metal complex dyes, metallophthalocyanine dyes, metalloporphyrin dyes and ruthenium complex dyes are preferred, and the ruthenium complex dyes are particularly preferred. The ruthenium complex dyes include, for example, complex dyes described in U.S. Patents 4,927,721, 4,684,537, 5,084,365, 5,350,644, 5,463,057 and 5,525,440, JP-A-7-249790 (the term "JP-A" as used herein means an "unexamined published Japanese patent application"), JP-W-10-504512 (the term "JP-W" as used herein means a "published Japanese national stage of international patent application"), PCT International Publication No. 98/50393 and JP-A-2000-26487.

Further, the ruthenium complex dyes used in the invention are preferably dyes represented by the following general formula (I):

(A₁)ₚRu(B-a) (B-b) (B-c) (I)

wherein A₁ represents a monodentate or bidentate ligand, which is preferably selected from the group consisting of Cl, SCN, H₂O, Br, I, CN, NCO, SeCN, β-diketones and derivatives of oxalic acid and dithiocarbamic acid; p is an integer of from 0 to 3; and B-a, B-b and B-c, which may be the same or different and may be any one or two of them, each independently represents an organic ligand selected from the group consisting compounds represented by the following formulas B-1 to B-8: 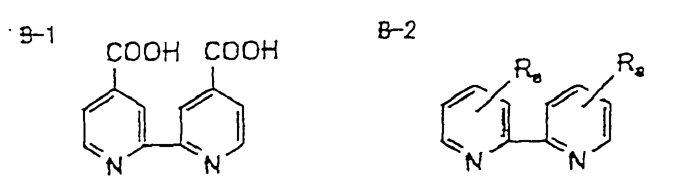 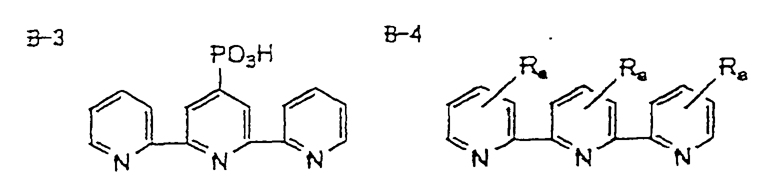 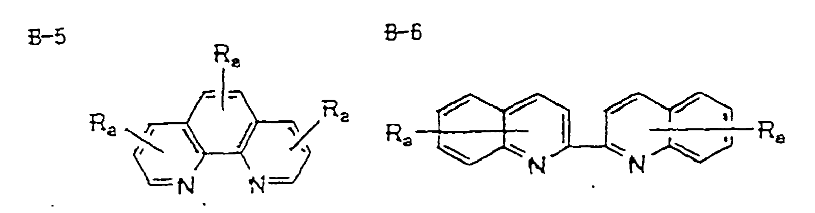 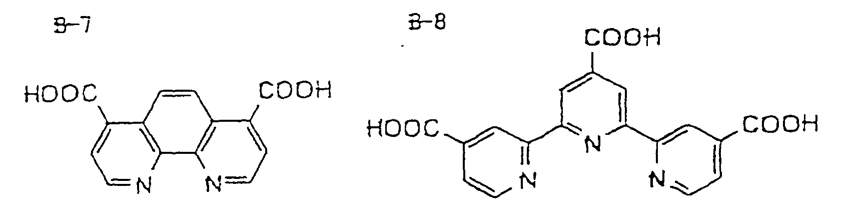 wherein Ra represents a hydrogen atom or a substituent group, which includes a halogen atom, a substituted or unsubstituted alkyl group having from 1 to 12 carbon atoms, a substituted or unsubstituted aralkyl group having from 7 to 12 carbon atoms, a substituted or unsubstituted aryl group having from 6 to 12 carbon atoms, or the above-mentioned acidic group (which may be in a salt form) or chelating group. Alkyl moieties of the alkyl group and the aralkyl group may be either straight-chain or branched, and aryl moieties of the aryl group and the aralkyl group may be either monocyclic or polycyclic (ring condensation or ring aggregation).

Preferred examples of the organic metal complex dyes are shown below.

| | | | | | | |
|---|---|---|---|---|---|---|
| No. | A₁ | p | B-a | B-b | B-c | Ra |
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | CN | 2 | B-7 | B-7 | - | - |
| R-5 | SCN | 2 | B-7 | B-7 | - | - |
| R-6 | SCN | 2 | B-1 | B-2 | - | 4,4'-COO⁻N⁺(C₄H₉-n)₄ |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 3 | B-8 | - | - | - |
| R-11 | CN | 3 | B-8 | - | - | - |
| R-12 | SCN | 1 | B-8 | B-2 | - | 4.4'-COO⁻N⁺(C₄H₉-n)₄ |
| R-13 | - | 0 | B-1 | B-1 | B-1 | - |

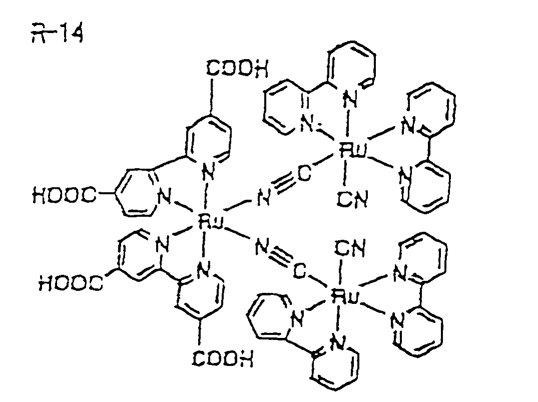

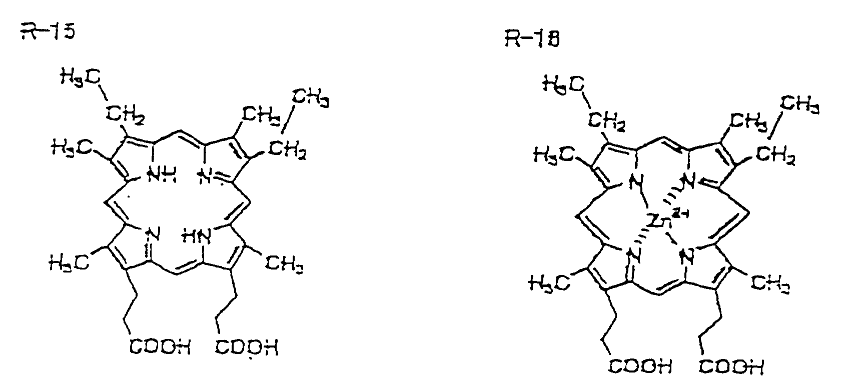

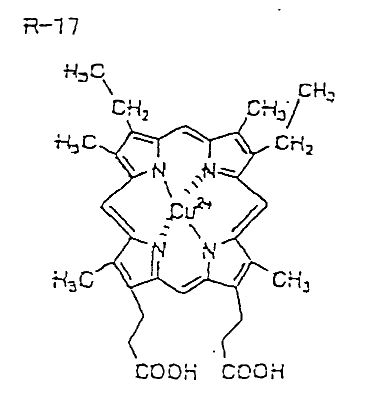

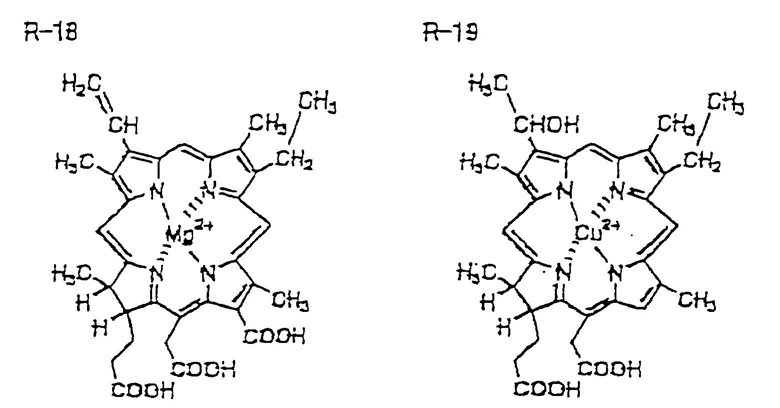

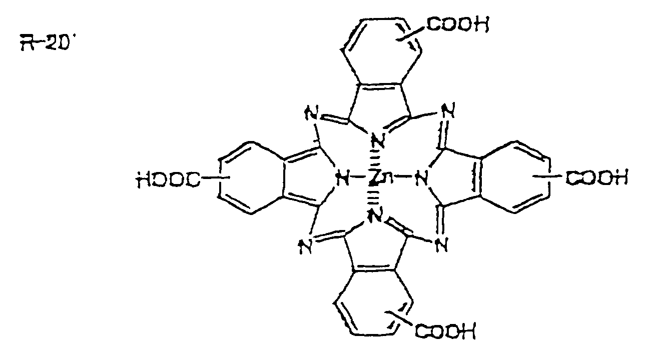

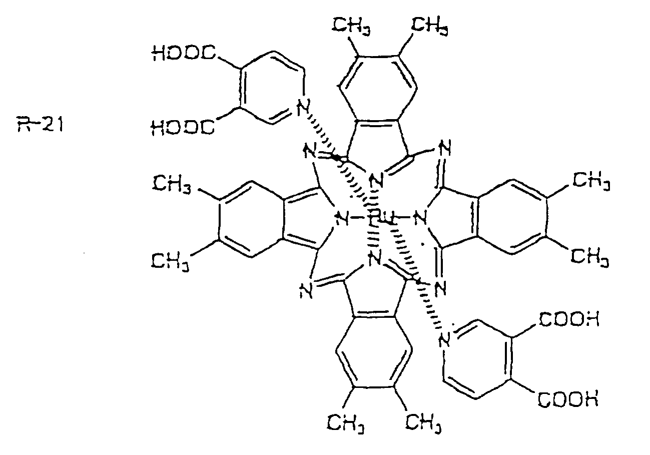

### (b) Methine Dye:

The methine dyes preferably used in the invention are polymethine dyes such as cyanine dyes, merocyanine dyes and squalirium dyes. Examples of the methine dyes preferably used in the invention are dyes described in JP-A-11-35836, JP-A-11-67285, JP-A-11-86916, JP-A-11-97725, JP-A-11-158395, JP-A-11-16378, JP-A-11-214730, JP-A-11-214731, JP-A-11-238905, JP-A-2000-26487, and European Patents 892,411, 911,841 and 991,092. Preferred examples of the methine dyes are shown below.

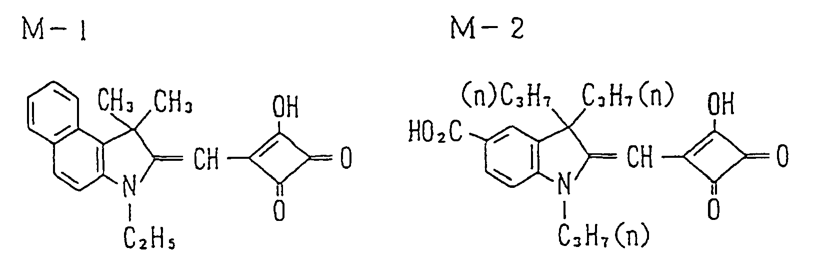

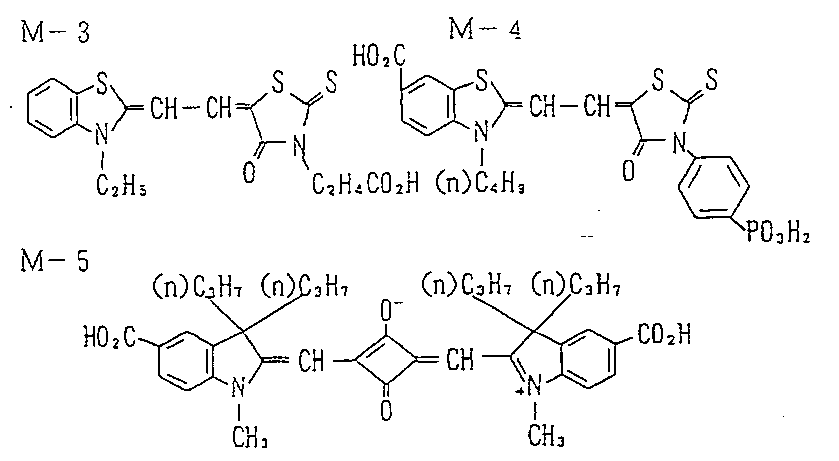

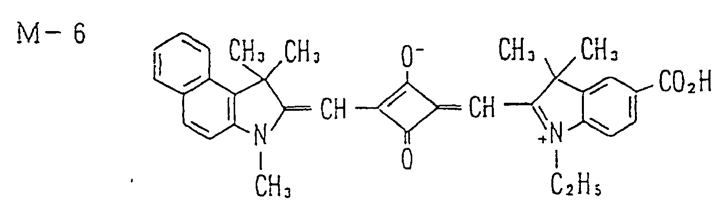

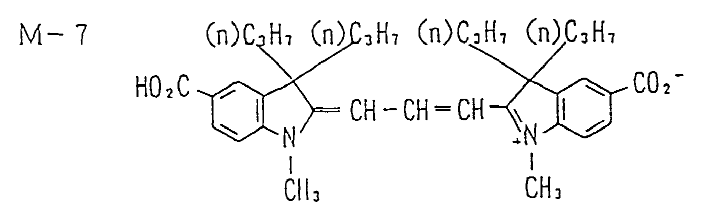

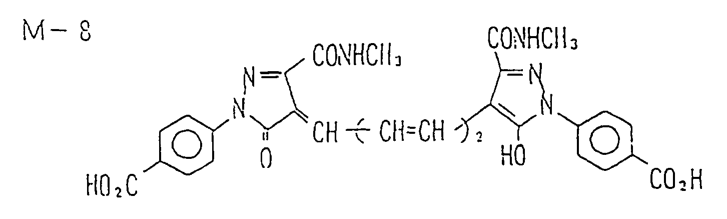

### (B-4) Adsorption of Dyes by Fine Semiconductor Particles:

For allowing the dyes to be adsorbed by the fine semiconductor particles, methods of immersing well-dried conductive supports having the fine semiconductor particle layers in dye solutions, or methods of coating the fine semiconductor particle layers with dye solutions can be used. In the former case, an immersion method, a dip method, a roller method and an air knife method are usable. In the case of the immersion method, the dyes may be adsorbed at room temperature or under heat reflux as described in JP-A-7-249790. The latter coating methods include a wire bar method, a slide hopper method, an extrusion method, a curtain method, a spin method and a spray method. Preferred examples of solvents for dissolving the dyes include alcohols (such as methanol, ethanol, t-butanol and benzyl alcohol), nitriles (such as acetonitrile, propionitrile and 3-methoxypropionitrile), nitromethane, hydrocarbon halides (such as dichloromethane, dichloroethane, chloroform and chlorobenzene), ethers (such as diethyl ether and tetrahydrofuran), dimethyl sulfoxide, amides (such as N,N-dimethylformamide and N,N-dimethylacetamide), N-methylpyrrolidone, 1,3-dimethylimidazolidinone, 3-methyloxazolidinone, esters (such as ethyl acetate and butyl acetate), carbonates (such as diethyl carbonate, ethylene carbonate and propylene carbonate), ketones (such as acetone, 2-butanone and cyclohexanone), hydrocarbons (such as hexane, petroleum ether, benzene and toluene) and mixed solvents thereof.

The total adsorption of the dye is preferably from 0.01 mmol to 100 mmol per unit surface area (m²) of porous semiconductor electrode substrate. The adsorption of the dye by the fine semiconductor particles is preferably from 0.01 mmol to 1 mmol per gram of fine semiconductor particles. Such adsorption of the dye gives sufficient sensitizing effect in the semiconductor. In contrast, when the adsorption of the dye is too small, the sensitizing effect becomes insufficient. On the other hand, when the adsorption is too much, the dye not adhered to the semiconductor suspends, which causes the sensitizing effect to be reduced. For increasing the adsorption of the dye, it is preferred that heat treatment is conducted before the adsorption. For avoiding adsorption of water on surfaces of the fine semiconductor particles, it is preferred that the dye adsorption operation is rapidly carried out at a temperature ranging from 60°C to 150°C without returning the temperature to ordinary temperature after the heat treatment. For reducing interaction between dye molecules such as coagulation, a colorless compound may be added to the dye to allow the compound to be co-adsorbed by the fine semiconductor particles. The compounds effective for this purpose are compounds having surface-active properties and structure, and examples thereof include carboxyl groupcontaining steroid compounds (for example, chenodeoxycholic acid).

The dye not adsorbed is preferably removed by washing rapidly after the adsorption. It is preferred that washing is performed with an organic solvent such as a polar solvent (for example, acetonitrile) or an alcohol solvent, using a wet washing tank. After the dye adsorption, the surfaces of the fine semiconductor particles may be treated with an amine. Preferred examples of the amines include pyridine, 4-t-butylpyridine and polyvinylpyridine. When they are liquid, they may be used as such or as solutions thereof in organic solvents.

### (C) Charge Transfer Layer:

The charge transfer layer for use in the invention is a layer having the function of rapidly reducing dye oxides and transferring holes injected at interfaces of the layers with the dyes to the counter electrodes. The charge transfer layer of the invention comprises the p-type inorganic compound semiconductor that is a hole transfer material and the thiocyanate.

### (C-1) p-Type Inorganic Compound Semiconductor:

For the p-type inorganic compound semiconductor, the band gap thereof is preferably so large as not to disturb the dye adsorption. Specifically, the band gap is preferably 2 eV or more, and more preferably 2.5 eV or more. The ionization potential of the p-type inorganic compound semiconductors is required to be smaller than that of dye adsorption electrodes from the conditions under which the holes of the dyes can be reduced. The preferred range of the ionization potential of the p-type inorganic compound semiconductors varies depending on the dyes used. In general, however, it is preferably from 4.5 eV to 5.5 eV, and more preferably from 4.7 eV to 5.3 eV. The p-type inorganic compound semiconductors are preferably monovalent cupper-containing compound semiconductors. The monovalent cupper-containing compound semiconductors preferably used in the invention include CuI, CuSCN, CuInSe₂, Cu(In,Ga)Se₂, CuGaSe₂, Cu₂O, CuS, CuGaS₂, CuInS₂ and CuAlSe₂. Of these, CuI and CuSCN are preferred, and CuI is most preferred. As the p-type inorganic compound semiconductors other than these, there can be used GaP, NiO, CoO, FeO, Bi₂O₃,MoO₂ and Cr₂O₃. The hole mobility of the charge transfer layers having the p-type inorganic compound semiconductors of the invention is preferably from 10⁻⁴ cm²/V·sec to less than 10⁴ cm²/V·sec, and more preferably from 10⁻³ cm²/V·sec to les than 10³ cm²/V·sec. The conductivity of the charge transfer layers is preferably from 10⁻⁸ S/cm to 10² S/cm, and more preferably from 10⁻⁶ S/cm to less than 10 S/cm. In the invention, the p-type inorganic compound semiconductors may be used as a mixture of two or more of them.

Further, p-type organic compound semiconductors may be used in combination with the above-mentioned inorganic compound semiconductors. Specific examples of the p-type organic compound semiconductors that can be used in combination include aromatic amines (for example, triarylamines and triphenyldiamines), triphenylene derivatives, polypyrrole compounds, polythiophene compounds, polyaniline derivatives and polyacetylene derivatives. In particular, compounds having cyano groups and/or alkoxyl groups (for example, triarylamine nitrile compounds) are preferred.

### (C-2) Thiocyanate:

Then, the thiocyanates are described. The term "thiocyanates" means all salts containing thiocyanic acid anions. Preferred examples of the thiocyanates used in the invention include alkali metal thiocyanates (for example, LiSCN, NaSCN, KSCN, RbSCN and CsSCN), substituted or unsubstituted ammonium thiocyanates, substituted or unsubstituted imidazolium thiocyanates, substituted or unsubstituted pyridinium thiocyanates, substituted or unsubstituted phosphonium thiocyanates, and thiocyanates having organic cations as counter ions. Of these, substituted or unsubstituted imidazolium thiocyanates and substituted or unsubstituted pyridinium thiocyanates are particularly preferred, and the substituted or unsubstituted imidazolium thiocyanates are most preferred.

Examples of the substituent groups include an alkyl group (e.g., methyl, ethyl, isobutyl, n-dodecyl, cyclohexyl, vinyl, allyl or benzyl), an aryl group (e.g., phenyl or naphthyl), a heterocyclic residue (e.g., pyridyl, imidazolyl, furyl, thienyl, oxazolyl, benzimidazolyl or quinolyl), a halogen atom (e.g., fluorine, chlorine or bromine), an alkoxyl group (e.g., methoxy, ethoxy, benzyloxy or a group containing a plurality of ethyleneoxy groups), an aryloxy group (e.g., phenoxy), an alkylthio group (e.g., methylthio or ethylthio), an arylthio group (e.g., phenylthio), a hydroxyl group, a cyano group, an amido group (e.g., acetylamino or benzoylamino), a sulfonamido group (e.g., methanesulfonylamino or benzenesulfonylamino), a ureido group (e.g., 3-phenylureido), a urethane group (e.g., isobutoxycarbonylamino or carbamoyloxy), an ester group (e.g., acetoxy, benzoyloxy, methoxycarbonyl or phenoxycarbonyl), a carbamoyl group (e.g., N-methylcarbamoyl or N,N-diphenylcarbamoyl), a sulfamoyl group (e.g., N-phenylsulfamoyl), an acyl group (e.g., acetyl or benzoyl), an amino group (e.g., amino, methylamino, dimethylamino, anilino or diphenylamino) and a sulfonyl (e.g., methylsulfonyl). These substituent groups may further have substituent groups.

Specific examples of the thiocyanates used in the invention are shown below. 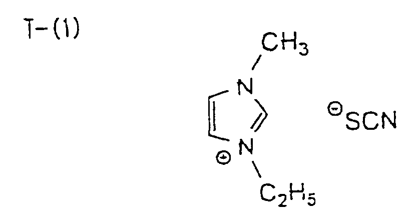 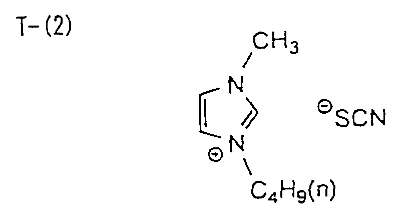 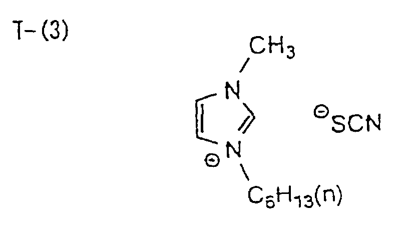 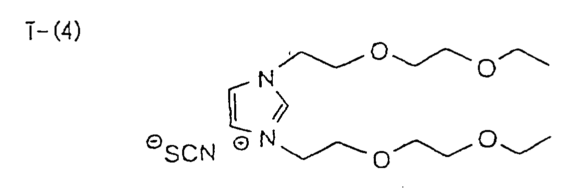 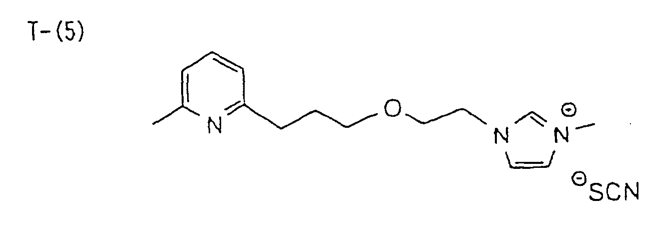 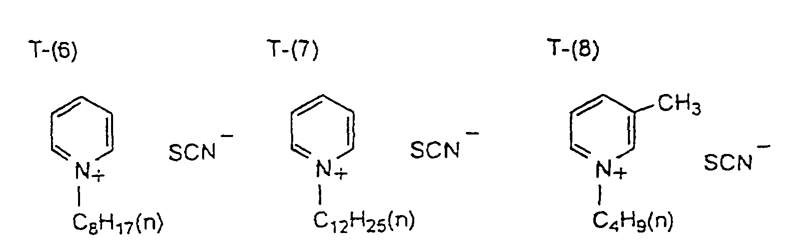 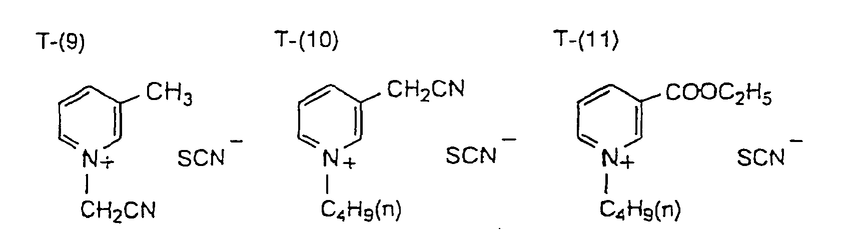 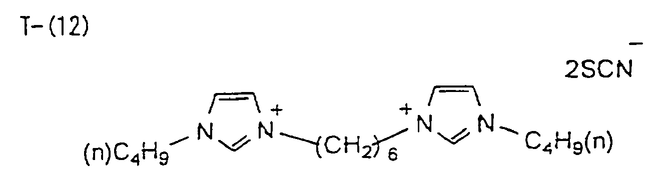 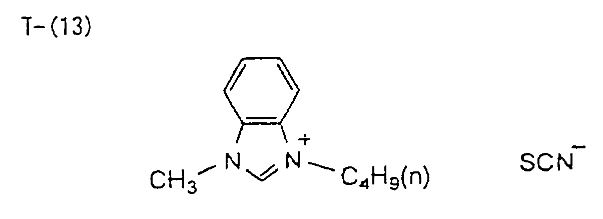 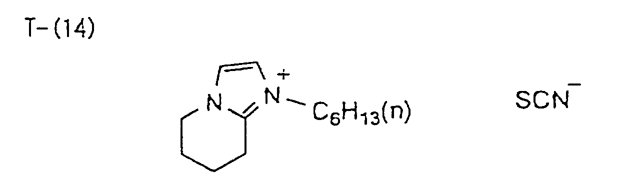 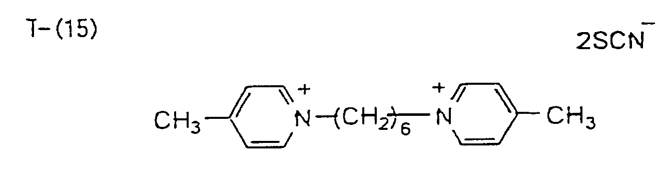 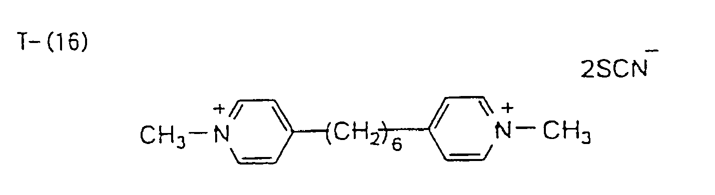 T-(17) (C₄H₉)₄N⁺ SCN⁻

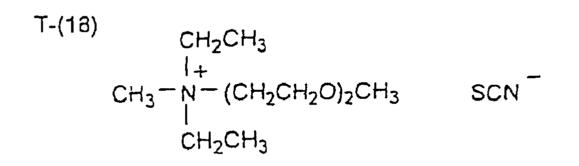

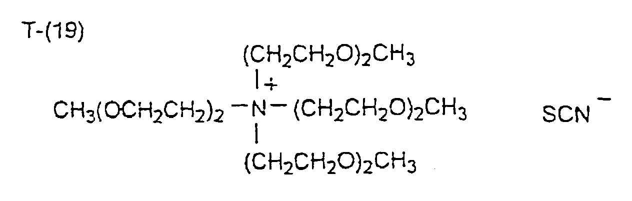

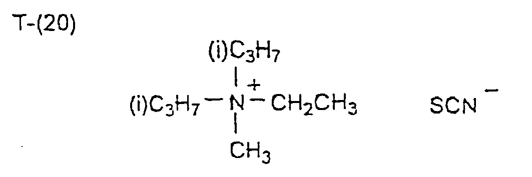

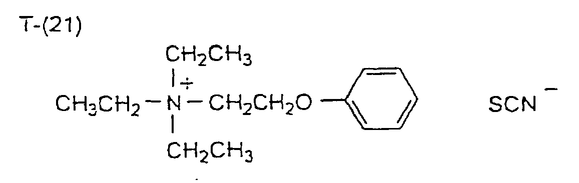

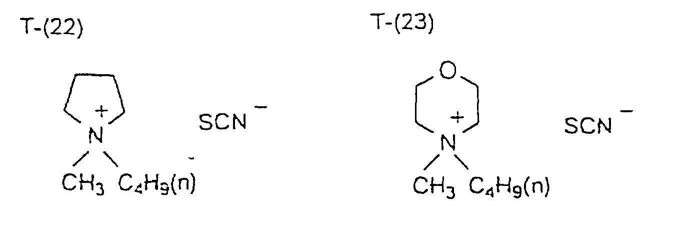

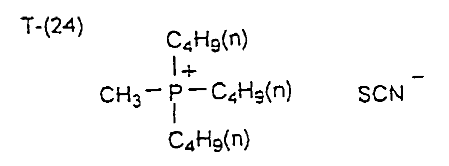

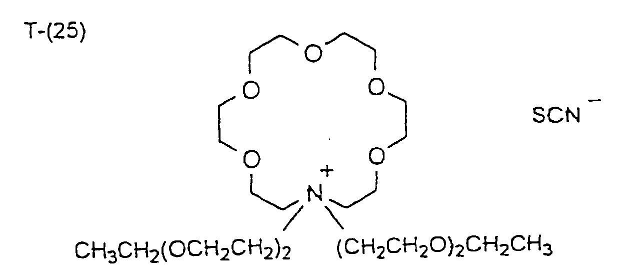

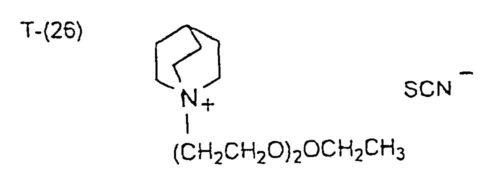

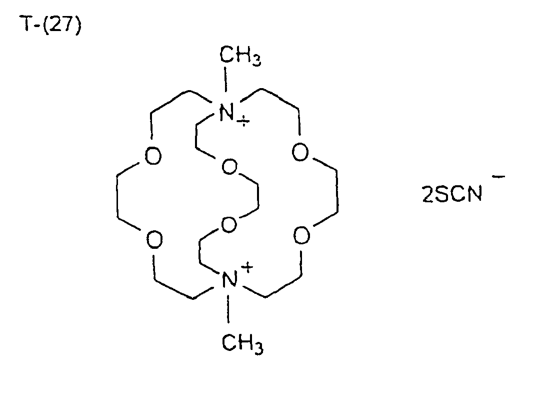

These thiocyanates may be used either alone or as a mixture of two or more of them. The total amount of the thiocyanate used is preferably from 0.2 mol% to less than 20 mol%, and more preferably from 0.5 mol% to less than 5 mol%, based on the p-type inorganic compound semiconductor. (C-3) Molten Salt:

It is preferred that the charge transfer layer of the invention contains molten salts, in addition to the above-mentioned p-type inorganic compound semiconductor and thiocyanate, for further improving their durability. The term "molten salts" means ionic pure substances (salts) showing fluidity in the neighborhood of ordinary temperature or mixtures of the salts. In the molten salt of the pure substance, at least one of a cation and an anion is usually an organic ion. In the molten salt of the mixture, at least one of ions of constituents is usually an organic ion. It is important that the molten salts added to the charge transfer layers of the invention do not substantially dissolve the p-type inorganic compound semiconductors.

The molten salts preferably used in the charge transfer layers include salts represented by any of the following general formulas (Y-a), (Y-b) and (Y-c):

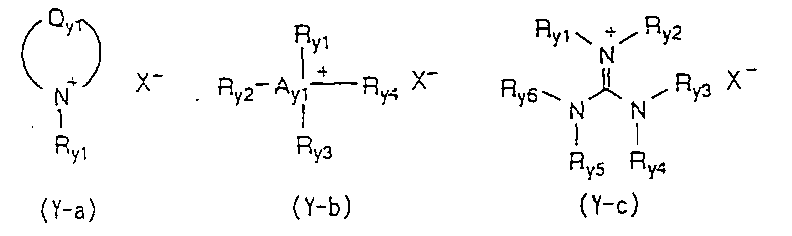

In general formula (Y-a), Q_{y1} represents an atomic group that can form a 5- or 6-membered aromatic cation together with a nitrogen atom. Q_{y1} is preferably composed of at least one atom selected from the group consisting of a carbon atom, a hydrogen atom, a nitrogen atom, an oxygen atom and a sulfur atom. The 5-membered ring formed by Q_{y1} is preferably an oxazole ring, a thiazole ring, an imidazole ring, a pyrazole ring, an isoxazole ring, a thiadiazole ring, an oxadiazole ring or a triazole ring, more preferably an oxazole ring, a thiazole ring, a triazole ring or an imidazole ring, and most preferably an imidazole ring. The 6-membered ring formed by Q_{y1} is preferably a pyridine ring, a pyrimidine ring, a pyridazine ring, a pyrazine ring or a triazine ring, and more preferably a pyridine ring. Q_{y1} may have a substituent group, and each of the substituent groups described above (for the thiocyanates) can be applied as the substituent group. Of these, the alkyl group, the alkoxyl group and the ethyleneoxy group-containing group are particularly preferred.

R_{y1} represents a substituted or unsubstituted alkyl or alkenyl group having 1 to 24 carbon atoms. R_{y1} may be straight-chain, branched or cyclic. Examples of such groups which can be preferably used include alkyl groups such as methyl, ethyl, propyl, isopropyl, pentyl, hexyl, octyl, 2-ethylhexyl, t-octyl, decyl, dodecyl, tetradecyl, 2-hexyldecyl, octadecyl, cyclohexyl and cyclopentyl, and alkenyl groups such as vinyl and allyl. When R_{y1} has a substituent group, preferred examples thereof are the same as given for Q_{y1}. In the invention, R_{y1} is preferably an alkyl group having from 2 to 18 carbon atoms or an alkenyl group having from 2 to 18 carbon atoms, and particularly preferably an alkyl group having from 2 to 6 carbon atoms.

In general formula (Y-b), A_{y1} represents a nitrogen atom or a phosphorus atom. A_{y1} is preferably a nitrogen atom. R_{y1} to R_{y4} each represents a substituted or unsubstituted alkyl or alkenyl group having 1 to 24 carbon atoms as described for R_{y1} in general formula (Y-a). Two or more of R_{y1} to R_{y4} may be combined with each other to form a non-aromatic ring containing A_{y1}. When R_{y1} to R_{y4} have substituent groups, preferred examples thereof are the same as given for R_{y1} in general formula (Y-a). R_{y1} to R_{y4} are each preferably an alkyl group having from 2 to 18 carbon atoms or an alkenyl group having from 2 to 18 carbon atoms, and particularly preferably an alkyl group having from 2 to 6 carbon atoms.

R_{y1} to R_{y6} in general formula (Y-c) have the same meaning as given for R_{y1} in general formula (Y-a). Two or more of R_{y1} to R_{y6} in general formula (Y-c) may be combined with each other to form a ring structure. R_{y1} to R_{y6} are each preferably an alkyl group having from 2 to 18 carbon atoms or an alkenyl group having from 2 to 18 carbon atoms, and particularly preferably an alkyl group having from 2 to 6 carbon atoms.

X⁻ represents a monovalent anion. According to the studies of the inventors, the property of dissolving the p-type inorganic compound semiconductors, particularly compound semiconductors containing monovalent copper, greatly depends on anion moieties. Anions strong in the property of dissolving the p-type inorganic compound semiconductors are unfavorable. Anions in which the pKa value of conjugate acids is 1 or less are preferred. X⁻ preferably used in the invention is a perchlorate ion, a BF4 ion, a PF6 ion, an SbC16 ion, a CF3SO3 ion, a bis(perfluoroalkylsulfonylimide) ion or a tris(perfluoroalkylsulfonylmethide) ion. The particularly preferred molten salts are bis(perfluoroalkylsulfonylimide) ions (for example, a bis(trifluoromethylsulfonyl)imide ion, a bis(pentafluoroethylsulfonyl)imide ion and a bis(heptadecafluorooctylsulfonyl)imide ion). The molten salts used in the invention are most preferably substituted or unsubstituted imidazolium bis(perfluoroalkylsulfonylimides).

The compounds represented by general formula (Y-a), (Y-b) or (Y-c) may form polymers with the interposition of Q_{y1} or R_{y1} to R_{y6}. when these molten salts are used in combination with the p-type inorganic compound semiconductors and the thiocyanates, the above-mentioned molten salts may be used either alone or as a mixture of two or more of them.

Examples of molten salts used in the invention are shown below.

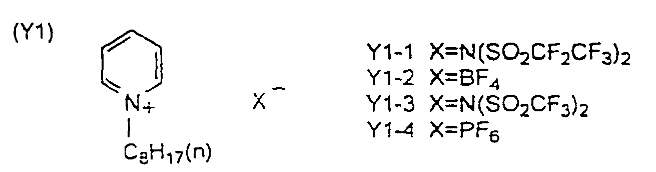

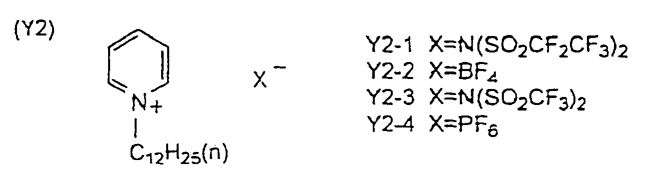

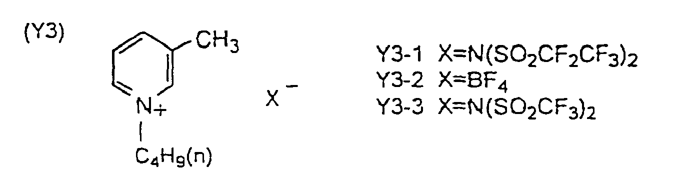

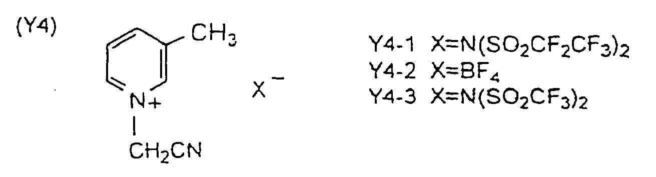

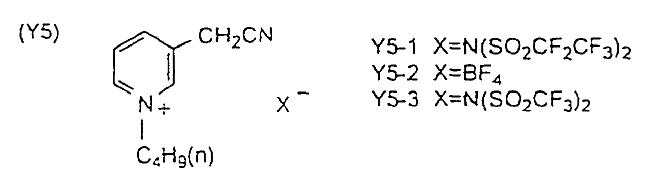

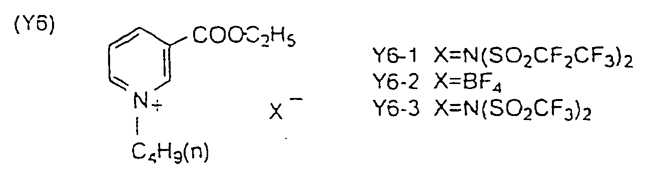

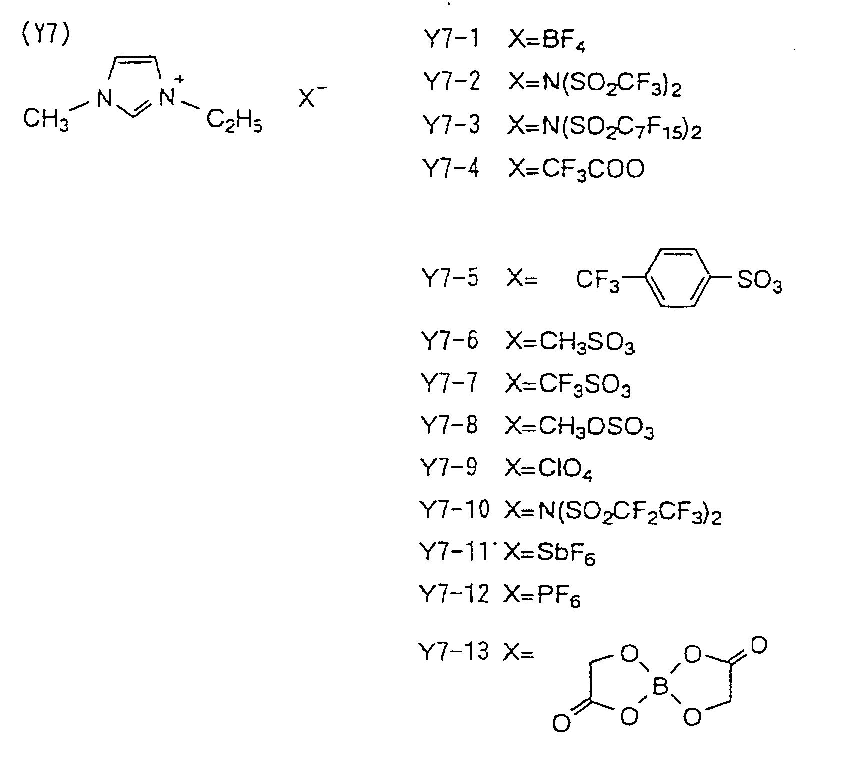

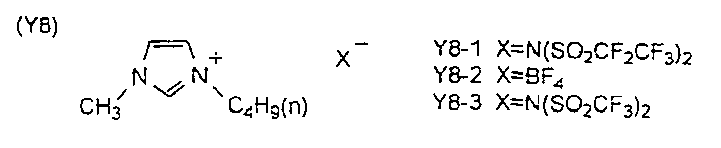

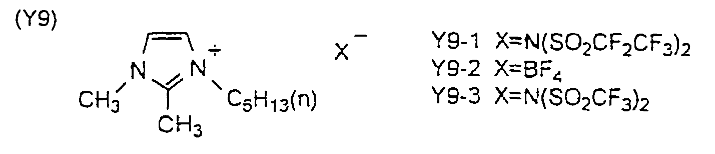

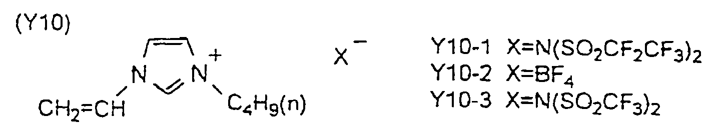

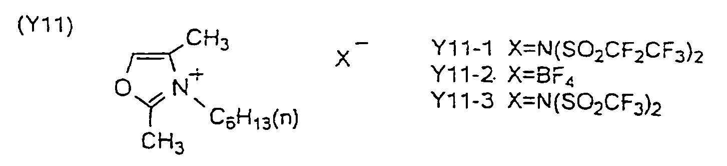

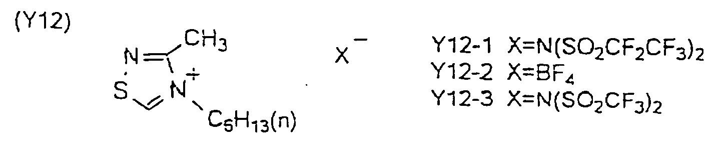

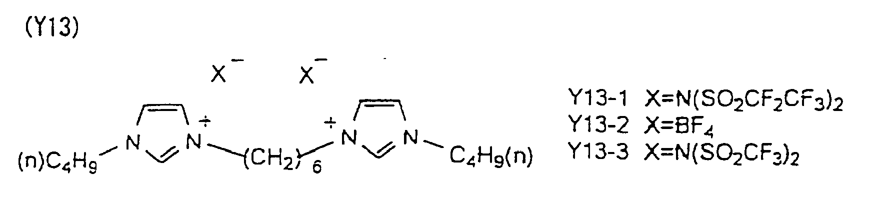

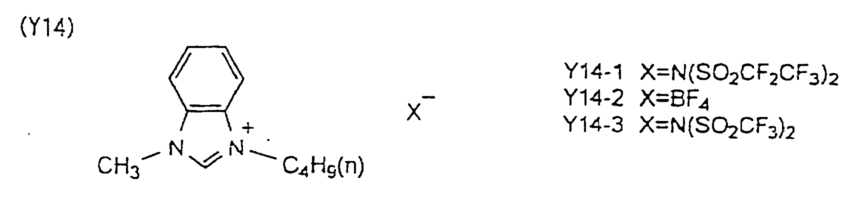

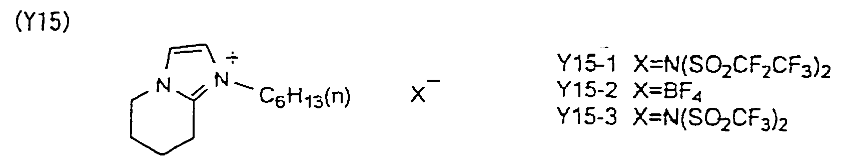

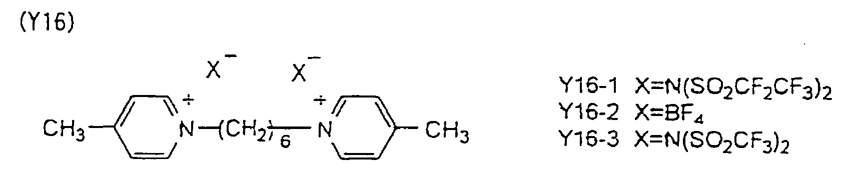

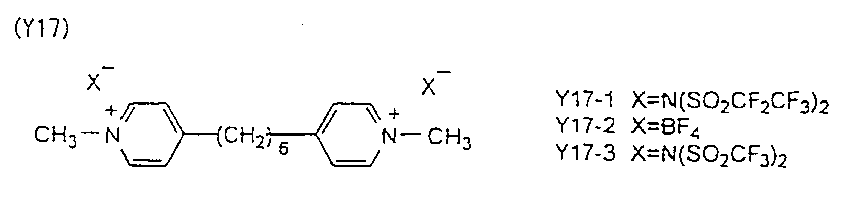

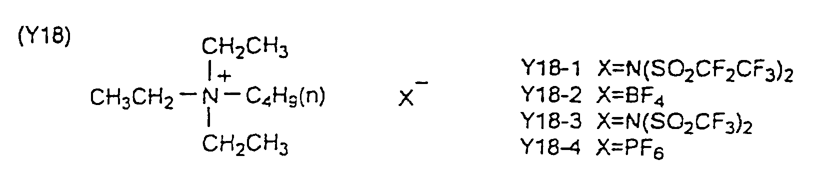

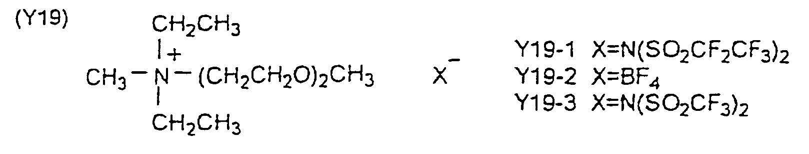

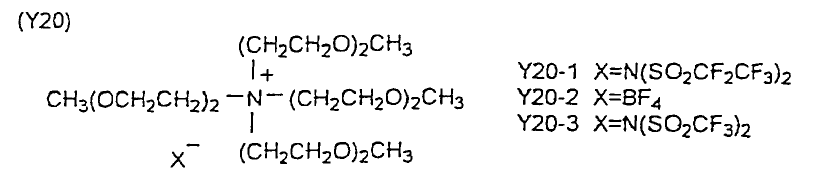

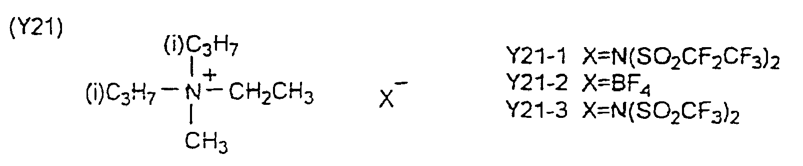

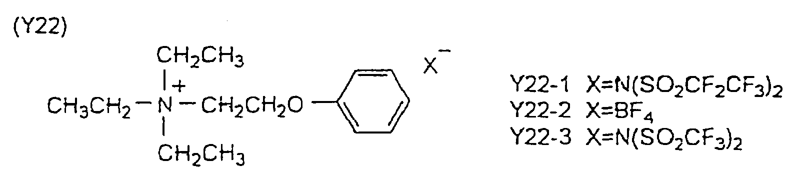

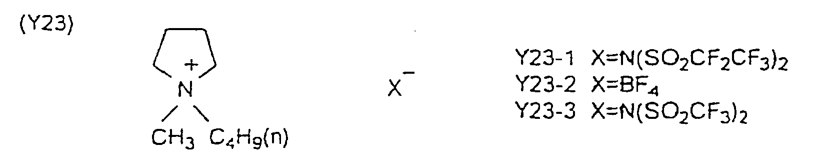

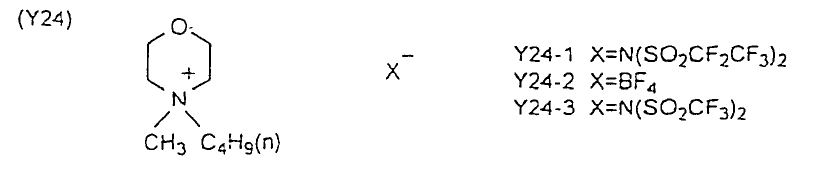

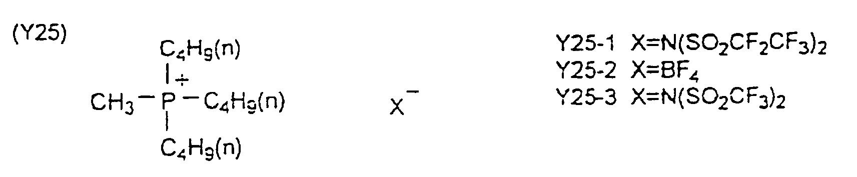

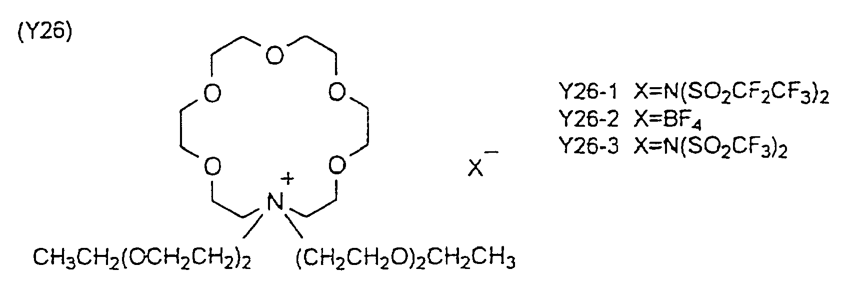

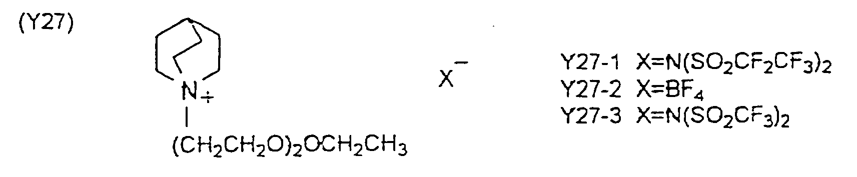

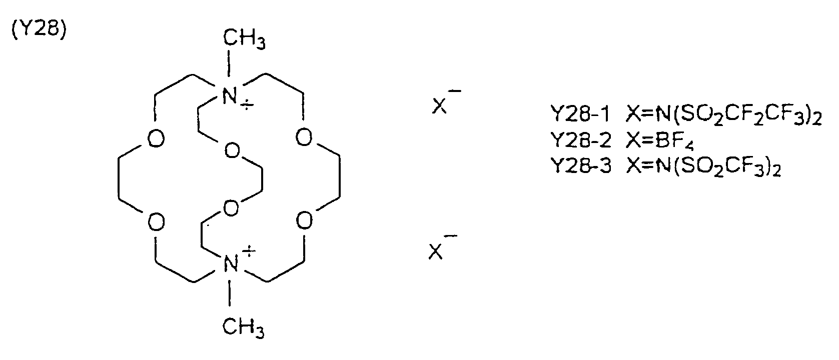

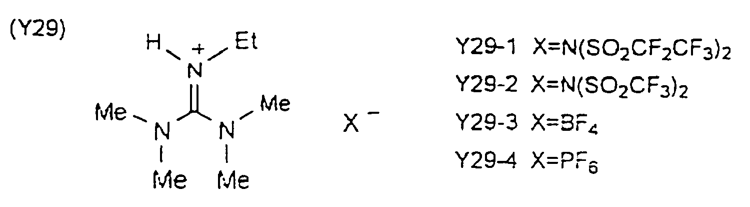

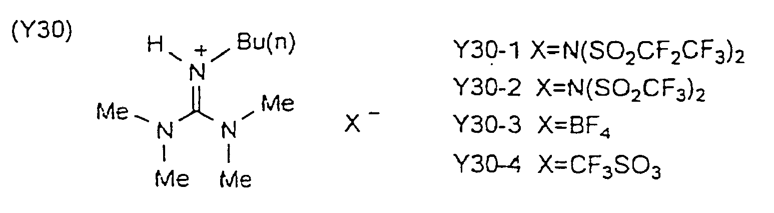

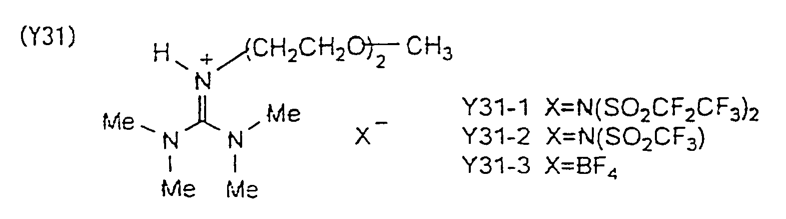

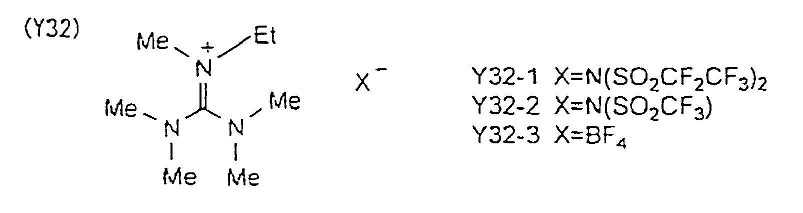

### (C-4) Other Additive:

The charge transfer layers of the invention can be improved in carrier concentration and conductivity by acceptor doping as needed. The doping may be either electrochemically conducted or chemically conducted using dopants. The dopants which are preferably used include but are not limited to iodine, tris(4-bromophenyl)aminium hexachloroantimonate, NOPF₆, SbCl₅, I₂, Br₂, HClO₄, (n-C₄H₉)₄ClO₄, trifluoroacetic acid, 4-dodecylbenzenesulfonic acid, 1-naphthalenesulfonic acid, FeCl₃, AuCl₃, NOSbF₆, AsF₅, NOBF₄, LiBF₄, H₃[PMo₁₂O₄₀], 7,7,8,8-tetracyanoquinodimethane (TCNQ) and Fullerene C60. When the dopant is added, the amount thereof added is preferably from 0.0001 mass% to less than 5 mass%, and more preferably from 0.001 mass% to less than 3 mass%, based on the p-type inorganic compound semiconductor.

It is also preferred that a nitrile compound (an organic compound having one or more cyano groups) is added to the charge transfer layer. Specific examples of the nitrile compounds include cyanoalkylated product of saccharides such as sucrose, cellulose and amylose, and cyanoalkylated product of alcohols such as sorbitol and PVA.

### (C-5) Formation of Charge Transfer Layer:

The thickness of the charge transfer layer of the invention is preferably from 0.005 µm to less than 100 µm, and more preferably from 0.01 µm to less than 50 µm, on the fine semiconductor particle-containing layer.

The charge transfer layer of the invention is obtained by forming a layer containing the p-type inorganic compound semiconductor and the thiocyanate on the photosensitive layer (dye adsorbing semiconductor).

When the charge transfer layer is formed by the coating.method, in addition to the p-type inorganic compound semiconductor and the thiocyanate, additives such as binder resins difficult to trap holes and coating property improving agents such as leveling agents and surfactants can be added and dissolved to prepare a coating solution. The coating solution can be applied by spin coating, dip coating, air knife coating, curtain coating, roller coating, wire bar coating, gravure coating or extrusion coating using a hopper described in U.S. Patent 2,681,294 to form the charge transfer layers. In coating, solvents may be used. The solvent preferably used in coating includes nitriles (for example, acetonitrile, methoxyacetonitrile and methoxypropionitrile) and pyridine compounds (for example, pyridine and picoline). Of these, acetonitrile is particularly preferred. The solvent is removed under heating or reduced pressure during or after coating. In the invention, the dye adsorption electrode is preferably heated upon coating. The substrate temperature upon coating is preferably from 30°C to less than 180°C, and more preferably from 40°C to less than 120°C.

When the charge transfer layer is allowed to contain the molten salt, the molten salt may be added to the above-mentioned coating solution for the charge transfer layer. However, it is preferred that after formation of the above-mentioned layer containing the p-type inorganic compound semiconductor and the thiocyanate, voids of the layer and the photosensitive layer are impregnated with the molten salt. The impregnation of the molten salt can be carried out by overcoating the charge transfer layer containing the p-type inorganic compound semiconductor and the thiocyanate with the molten salt. Preferred examples of the overcoating method include a cast method, a spin coat method and an immersion method. For allowing the molten salt to penetrate into the photosensitive layer and the charge transfer layer after overcoating, deaeration is preferably conducted under reduced pressure. Then, excess molten salts are preferably soaked up with filter papers. The amount of the molten salt coated is from 0.1 g/m² to 10 g/m², and more preferably from 0.5 g/m² to 5 g/m².

### (D) Counter Electrode:

The counter electrode may have a single layer structure of a counter electrode conductive layer comprising a conductive material, or comprises a counter electrode conductive layer and a support substrate, similarly to the conductive support described above. The conductive material for use in the counter electrode conductive layer includes metals (for example, platinum, gold, silver, copper, aluminum, magnesium and indium), carbon and conductive metal oxides (indium-tin complex oxides and fluorine-doped tin oxide). Of these, platinum, gold, silver, copper, aluminum and magnesium can be preferably used as the counter electrode layer. The support substrate of the counter electrode is preferably made of glass or plastics, and used with the above-mentioned conductive material applied or vapor-deposited thereon. Although there is no particular limitation on the thickness of the counter electrode conductive layer, it is preferably from 3 nm to 10 µm. It is preferred that the counter electrode layer is lower in surface resistance.
The surface resistance is preferably 50 Ω/square or less, and more preferably 20 Ω/square or less.

Light may be irradiated from any one or both of the conductive support and the counter electrode, so that arrival of light at the photosensitive layer only requires that at least one of the conductive support and the counter electrode is substantially transparent. From the viewpoint of improvement in the efficiency of electric power generation, it is preferred that the conductive support is made transparent and light is irradiated from the conductive support side. In this case, it is preferred that the counter electrode has light-reflective properties. As such counter electrodes, there can be used glass or plastics vapor-deposited with metals or conductive oxides, or metal films.

The counter electrode may be manufactured by directly coating, plating or vapor-depositing the charge transfer layer with the conductive material, or attaching the conductive layer-containing substrate to the charge transfer layer on its conductive layer side. Similarly to the conductive support, a metal lead is preferably used for decreasing the resistance of the counter electrode, particularly when the counter electrode is transparent. Materials for the metal leads, methods for attaching them to the counter electrodes, and the reduction in the amount of incident light caused by the attachment of the metal leads are the same as with the conductive supports.

### (E) Other Layers:

For preventing electrical short of the counter electrode and the conductive support, it is preferred that a dense semiconductor film layer is previously provided as an undercoat layer between the conductive support and the photosensitive layer. When electron transfer materials or hole transfer materials are used in the charge transfer layer, it is particularly preferred. The undercoat layer is preferably formed of TiO₂, SnO₂, Fe₂O₃, WO₃, ZnO and Nb₂O₅, and more preferably TiO₂. The undercoat layer can be provided by, for example, a sputtering method, as well as a spray pyrolysis method described in Electrochim. Acta, 40, 643-652 (1995). The thickness of the undercoat layer is preferably from 5 nm to 1000 nm, and more preferably from 10 nm to 500 nm.

Further, a functional layer such as a protective layer or an anti-reflection layer may be provided on an outer surface or outer surfaces of one or both of the conductive support acting as an electrode and the counter electrode, between the conductive layer and the substrate, or in an intermediate portion of the substrate. For the formation of these functional layers, coating methods, vapor deposition methods or attaching methods can be used depending on their materials.

### (F) Specific Examples of Internal Structure of Photoelectric conversion device:

As described above, the internal structure of the photoelectric conversion device can take various forms depending on their purpose. Classifying them into two broad categories, a structure in which the incidence of light on both faces of the device is possible and a structure in which the incidence of light on only one face of the device is possible are available. Internal structures of the photoelectric conversion device, which can be preferably applied in the invention, are illustrated in Figs. 2 to 9.

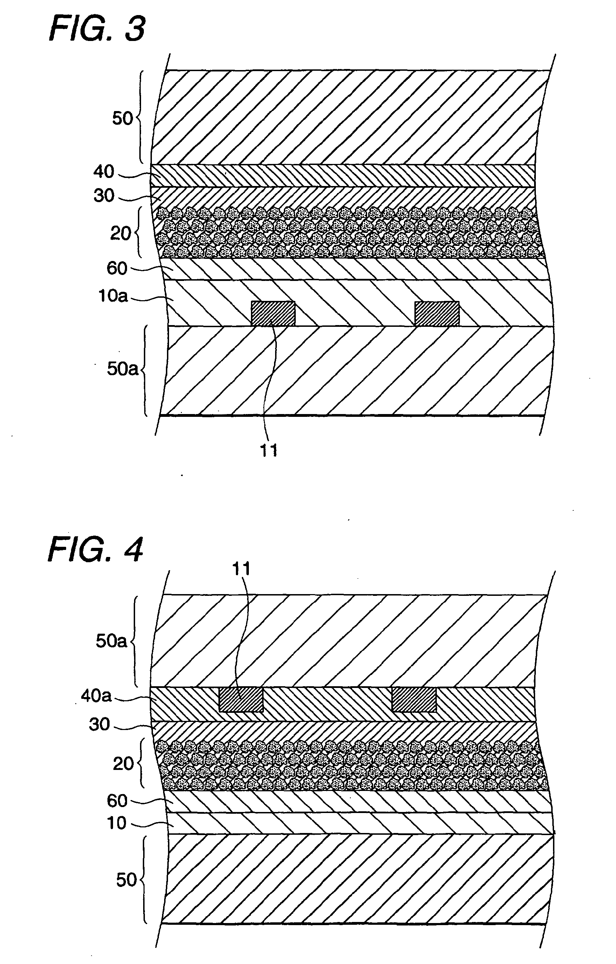

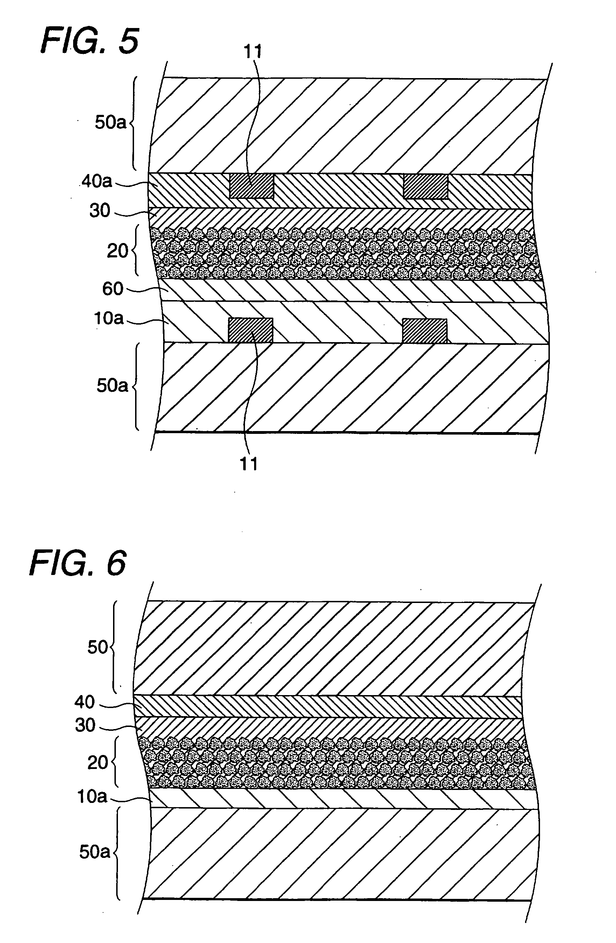

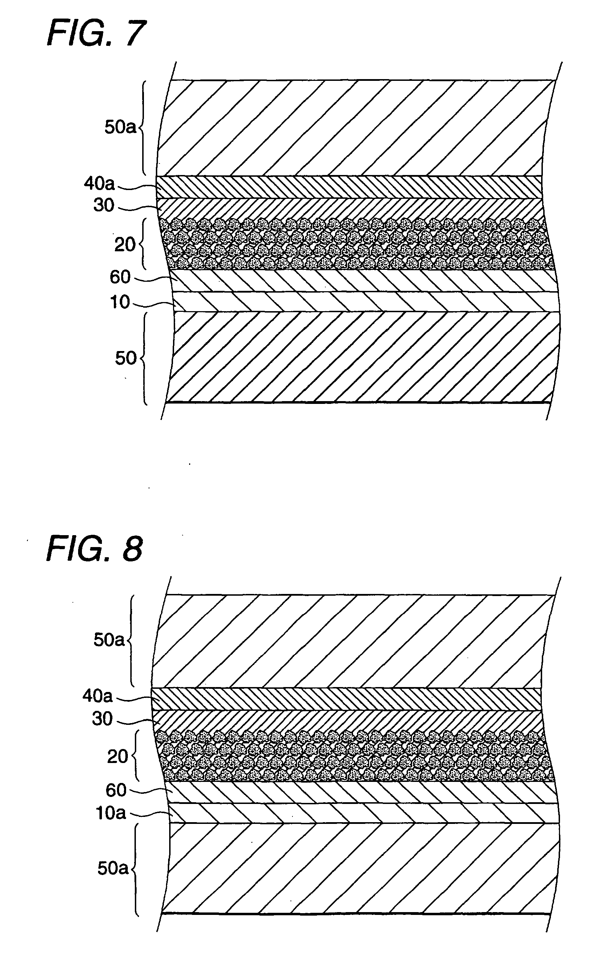

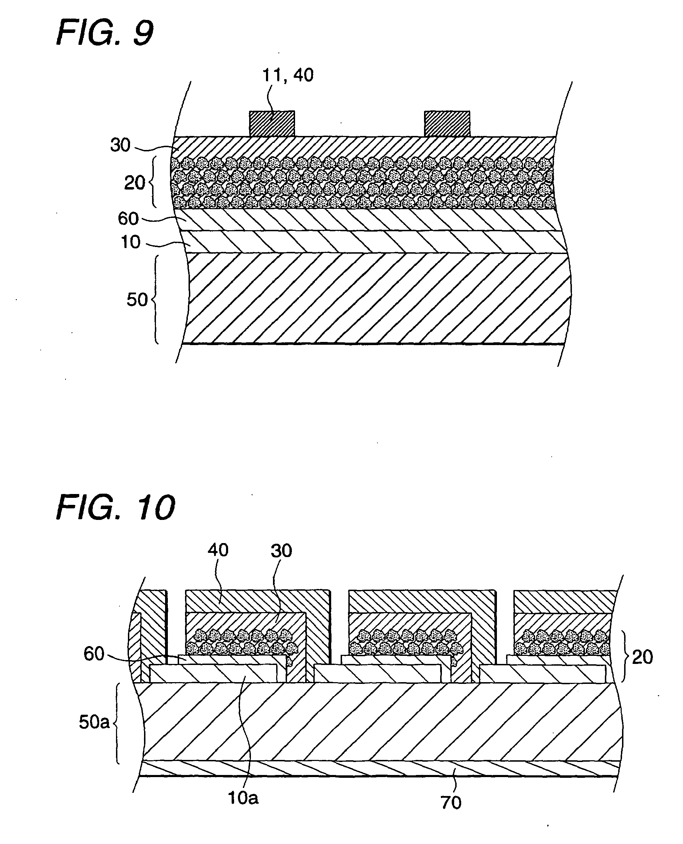

Referring to Fig. 2, a photosensitive layer 20 and a charge transfer layer 30 are allowed to intervene between a transparent conductive layer 10a and a transparent counter electrode conductive layer 40a, resulting in a structure in which light is incident on both faces of the device. Referring to Fig. 3, metal leads 11 are partly mounted on a transparent substrate 50a, a transparent conductive layer 10a is further provided thereon, a undercoat layer 60, a photosensitive layer 20, a charge transfer layer 30 and a counter electrode conductive layer 40 are formed in this order, and a support substrate 50 is further disposed, resulting in a structure in which light is incident on the conductive layer side of the device. Referring to Fig. 4, a conductive layer 10 is further formed on a support substrate 50, a photosensitive layer 20 is provided with the interposition of an undercoat layer 60, a charge transfer layer 30 and a transparent counter electrode conductive layer 40a are further arranged thereon in this order, and a transparent substrate 50a partly provided with metal leads 11 is disposed thereon with the metal leads positioned inside, giving a structure in which light is incident on the counter electrode side of the device. Referring to Fig. 5, metal leads 11 are partly mounted on a transparent substrate 50a, and a transparent conductive layer 10a (or 40a) is further provided thereon. Then, an undercoat layer 60, a photosensitive layer 20 and a charge transfer layer 30 are allowed to intervene between the pair of sheets prepared above, giving a structure in which light is incident on both faces of the device. Referring to Fig. 6, a transparent conductive layer 10a, a photosensitive layer 20, a charge transfer layer 30 and a counter electrode conductive layer 40 are provided on a transparent substrate 50a in this order, and a support substrate 50 is arranged thereon, giving a structure in which light is incident on the conductive layer side of the device. Referring to Fig. 7, a conductive layer 10 is formed on a support substrate 50, a photosensitive layer 20 is provided with the interposition of an undercoat layer 60, a charge transfer layer 30 and a transparent counter electrode conductive layer 40a are further arranged thereon in this order, and a transparent substrate 50a is disposed thereon, giving a structure in which light is incident on the counter electrode side of the device. Referring to Fig. 8, a transparent conductive layer 10a is formed on a transparent substrate 50a, a photosensitive layer 20 is provided with the interposition of an undercoat layer 60, a charge transfer layer 30 and a transparent counter electrode conductive layer 40a are further arranged thereon in this order, and a transparent substrate 50a is disposed thereon, resulting in a structure in which light is incident on both faces of the device. Referring to Fig. 9, a conductive layer 10 is formed on a support substrate 50, a photosensitive layer 20 is provided with the interposition of an undercoat layer 60, a solid charge transfer layer 30 is further arranged thereon, and a partial counter electrode conductive layer 40 or metal leads 11 are provided thereon, resulting in a structure in which light is incident on the counter electrode side of the device.

### 2. Photoelectric Cells

The photoelectric cell of the invention is a cell in which the above-mentioned photoelectric conversion device is allowed to do work by external loads. Of the photoelectric cells, cells in which the charge transfer materials mainly comprise ion transfer materials are particularly called photoelectrochemical cells, and cells mainly aiming at electric power generation by solar light are called solar cells. The photoelectric cells are preferably sealed over their side faces with polymers or adhesives, for preventing deterioration of their constituents and evaporation of their contents. The external circuits themselves connected to the conductive supports and the counter electrodes through the leads may be known ones. When the photoelectric conversion device of the invention is applied to the solar cell, the internal structure of the cell is basically the same as the above-mentioned internal structure of the photoelectric conversion device. The dye sensitization type solar cell of the invention can take a module structure basically similar to those of the conventional solar cells. The solar cell module generally has a structure in which the cell is constituted on a metal or ceramic support substrate, and covered with a filling resin or protective glass, thereby incorporating light from the side opposite to the support substrate. However, it is also possible to use a transparent material such as tempered glass for the support substrate, and constituting the cell thereon, thereby incorporating light from the transparent support substrate side. Specifically, module structures called the super straight type, the sub straight type and the potting type, and substrate-integral module structures used in amorphous silicon solar cells are known. The dye sensitization type solar cell of the invention can also be appropriately selected from these module structures, depending on the purpose for use, the place where they are used, and the circumstances. Specifically, structures and forms described in Japanese Patent Application No. 11-8457 are preferred. An example of the module structure is shown in Fig. 10.

The invention will be illustrated in greater detail with reference to the following examples, using CuI as the p-type inorganic compound semiconductor.

### EXAMPLES

### 1. Preparation of Titanium Dioxide Dispersion

In a stainless steel vessel having an internal volume of 200 ml, the inside of which was coated with Teflon, 15 g of titanium oxide (Degussa P-25, manufactured by Nippon Aerosil K.K.), 45 g of water, 1 g of a dispersing agent (Triton X-100, manufactured by Aldrich) and 30 g of zirconia beads having a diameter of 0.5 mm manufactured by Nikkato K.K.) were placed, and dispersed for 2 hours at 1500 rpm using a sand grinder mill (manufactured by Aimex). The zirconia beads were removed from the resulting dispersion by filtration. In this case, dispersed titanium dioxide had an average particle size of 2.5 µm (the primary particles had a size of from 20 nm to 30 nm). The particle size at this time was measured with a master sizer manufactured by MALVERN.

### 2. Preparation of Dye-Adsorbed TiO₂ Electrode

A part (5 mm from an end) on the conductive face side of conductive glass (25 mm X 100 mm, sheet resistivity: 10 Ω/square, manufactured by Nippon Sheet Glass Co., Ltd.) coated with fluorine-doped tin oxide was covered with glass to protect it, and then, a titanium dioxide film (thickness: 60 nm) was formed by a spray pyrolysis method described in Electrochim. Acta, 40, 643-652 (1995). An adhesive tape was put on a part (3 mm from an end) on the conductive face side as a spacer, and the above-mentioned titanium oxide dispersion was applied thereon by use of a glass rod. After the application, the adhesive tape was separated, followed by air drying at room temperature for 1 hour. Then, this glass was placed in an electric furnace (FP-32 type muffle furnace, manufactured by Yamato Scientific Co., Ltd.), and burned at 550°C for 30 minutes. Then, the glass was taken out, and cooled for 7 minutes, followed by immersion in a solution of Ru complex dye (R-1) in ethanol (3 X 10⁻⁴ mol/liter) at room temperature for 12 hours. The dye-adsorbed glass was washed with acetonitrile, air-dried, and cut to 25 mm X 10 mm in width, thereby obtaining electrode A. The thickness of the photosensitive layer thus obtained (dye-adsorbed titanium oxide layer) was 4.0 µm, and the amount of the fine semiconductor particles coated was 6 g/m².

### 3. Formation of Charge Transfer Layer

Charge transfer layer was formed by the following method.

Thiocyanates shown in Table 1 were each added to and dissolved in a solution of CuI in acetonitrile (3.2 mass%) to prepare respective coating solutions. For comparison, coating solutions were also prepared in the same manner as described above with the exception that no thiocyanates were contained. An exposed portion of the conductive face of electrode A prepared in (2) of Example and the periphery of a cell extending over 1 mm in width were protected with an adhesive tape, followed by standing on a hot plate heated at 100°C for 2 minutes. Then, 0.2 ml of each coating solution was slowly applied by use of an Eppendorf for about 10 minutes while evaporating acetonitrile, followed by standing on a hot plate for 2 hours to form a charge transfer layer. The thickness of the charge transfer layer formed at this time was from 15 µm to 30 µm. The electrode was coated with each molten salt shown in Table, and allowed to stand under a reduced pressure of 1000 Pa or less. Then, an excess molten salt was soaked up with a filter paper to remove it.

### 4. Preparation of Photoelectric Cell

The charge transfer layer formed as described above was overlaid with platinum-deposited glass (the thickness of a platinum layer: 1 µm, the thickness of glass: 1.1 mm, size: 1 cm X 2.5 cm), and pinched with a clip to prepare a photoelectric cell. Thus, photoelectric cells C-1 to C-12 and photoelectric cell RC-13 for comparison, in each of which the glass 50a, the conductive layer 10a, the TiO2 undercoat layer 60, the dye adsorbed Tio2 electrode layer, the charge transfer layer 30 and the counter layer 40 were laminated in this order.

### 5. Measurement of Photoelectric Conversion Efficiency

Light of a 500-W xenon lamp (manufactured by Ushio Inc.) was passed through a spectral filter (AM 1.5 manufactured by Oriel), thereby generating simulated sunlight. The intensity of the light was 100 mW/cm².

A crocodile clip was connected to each of the conductive glass and the counter electrode of the above-mentioned photoelectric cell, the cell was irradiated with the simulated sunlight, and generated electricity was measured with a current-voltage measuring device (KEITHLEY, Type SMU 238) to determine the conversion efficiency. This measurement was conducted from 3 hours to 5 hours after preparation of the cell (measurement of initial performance). For examining the durability of the photoelectric cell, the photoelectric cell described above was stored under storage conditions of 40°C and 40% RH for 5 days, and then the photoelectric conversion performance was similarly measured again. The conversion efficiency in measurement of the initial performance and the conversion efficiency after storage are shown in Table 1.

**TABLE 1**

| Cell No. | | Thiocyanate | Molten Salt | Initial Conversion Efficiency | Conversion Efficiency after Storage |
|---|---|---|---|---|---|
| C-1 | Invention | T-(1) | Y7-2 | 3.5% | 3.4% |
| C-2 | Invention | T-(2) | Y7-2 | 3.4% | 3.3% |
| C-3 | Invention | T-(8) | Y7-2 | 2.9% | 2.7% |
| C-4 | Invention | T-(17) | Y7-2 | 2.9% | 2.7% |
| C-5 | Invention | NH₄SCN | Y7-2 | 2.6% | 2.3% |
| C-6 | Invention | NaSCN | Y7-2 | 2.5% | 2.1% |
| C-7 | Invention | T-(1) | Y3-3 | 3.1% | 2.7% |
| C-8 | Invention | T-(1) | Y7-3 | 3.4% | 3.3% |
| C-9 | Invention | T-(1) | Y7-7 | 2.8% | 2.4% |
| C-10 | Invention | T-(1) | Y7-9 | 2.9% | 2.5% |
| C-11 | Invention | T-(1) | Y7-10 | 3.3% | 3.2% |
| C-12 | Invention | T-(1) | Y18-3 | 3.0% | 2.7% |
| C-13 | Invention | T-(1) | None | 2.2% | 1.5% |
| RC-14 | Comparison | None | Y7-2 | 1.2% | 0.8% |
| RC-15 | Comparison | None | None | 0.5% | 0.3% |

A comparison between cells C-1 and C-2 of the invention and cells RC-14 and RC-15 containing no thiocyanates shows that the conversion efficiency and the durability are both significantly improved by the invention. Further, a comparison between cell C-13 and other cells of the invention shows that the use of the molten salt together with the thiocyanate is preferred in terms of the conversion efficiency and the durability.

In a comparison of cells C-1 to C-6 of the invention, cells C-1 and C-2 are excellent in the conversion efficiency. It also indicates that the imidazolium salts are preferred as the thiocyanates. In a comparison of cells C-1 and C-7 to C-12, cells C-1, C-7, C-8, -11 and C-12 are excellent in the conversion efficiency and the durability. It also indicates that the bis(perfluoroalkylsulfonyl)imide salts are preferred as the molten salts.

On the whole, cells C-1, C-2, C-8 and C-11 are particularly excellent in both the conversion efficiency and the durability. This reveals that a combination of imidazolium thiocyanates as the thiocyanates with imidazolium bis(perfluoroalkylsulfonyl)imides as the molten salts provides the best performance.

As described above in detail, the photoelectric conversion devices of the invention using the p-type hole transfer materials are high in photoelectric conversion efficiency, and less in characteristic deterioration with time. Accordingly, the photoelectric cells comprising such photoelectric conversion devices are very effective as solar cells.

## Claims

1. A dye-sensitized photoelectric conversion device comprising a conductive layer (10), a photosensitive layer (20), a charge transfer layer (30) and a counter electrode (40), wherein said charge transfer layer (30) comprises a p-type inorganic compound semiconductor and a thiocyanate, **characterised in that** said thiocyanate being a molten salt.

2. The photoelectric conversion device according to claim 1, wherein said p-type inorganic compound semiconductor is a monovalent cupper-containing compound semiconductor.

3. The photoelectric conversion device according to claim 2, wherein said monovalent cupper-containing compound semiconductor is CuI or CuSNC.

4. The photoelectric conversion device according to any one of claims 1 to 3, wherein said thiocyanate is a substituted or unsubstituted imidazolium thiocyanate or a substituted or unsubstituted pyridinium thiocyanate.

5. The photoelectric conversion device according to any one of claims 1 to 4, wherein said thiocyanate is used in a molar amount of from not less than 0.2 mol% to less than 20 mol% based on the amount of the p-type inorganic compound semiconductor.

6. The photoelectric conversion device according to any one of claims 1 to 5, wherein said charge transfer layer (30) further contains a molten salt other than the thiocyanate.

7. The photoelectric conversion device according to claim 6, wherein said molten salt other than the thiocyanate is represented by the following general formula (Y-a), (Y-b) or (Y-c): 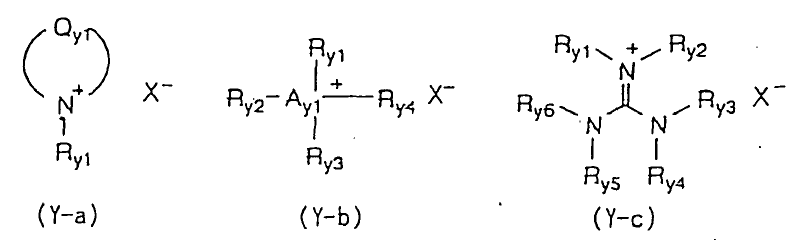 wherein Q_{y1} represents an atomic group which can form a 5- or 6-membered aromatic cation together with a nitrogen atom; R_{y1}, R_{y2}, R_{y3}, R_{y4}, R_{y5} and R_{y6} each independently represents a substituted or unsubstituted alkyl or alkenyl group having 1 to 24 carbon atoms; A_{y1} represents a nitrogen atom or a phosphorus atom; and X⁻ represents a monovalent anion.

8. The photoelectric conversion device according to claim 7, wherein Q_{y1} in formula (Y-a) is an imidazole ring or a pyridine ring.

9. The photoelectric conversion device according to claim 7, wherein X⁻ of said molten salt is a bis (perfluoroalkylsulfonyl) imide anion.

10. The photoelectric conversion device according to any one of claims 1 to 9, wherein said photosensitive layer (20) contains fine semiconductor particles (21) sensitized with a dye.

11. The photoelectric conversion device according to claim 10, wherein said fine semiconductor particles (21) are fine titanium dioxide particles.

12. The photoelectric conversion device according to claim 10 or 11, wherein said dye is a ruthenium complex dye or a polymethine dye.

13. The photoelectric conversion device according to any one of claims 1 to 12, wherein the photoelectric conversion device has an undercoat layer (60) comprising an oxide semiconductor between said conductive layer (10) and said photosensitive layer (20).

14. A photoelectric cell using a photoelectric conversion device according to any one of claims 1 to 13.

15. A solar cell module using a photoelectric conversion device according to any one of claims 1 to 13.

16. A method for manufacturing a dye-sensitized photoelectric conversion device comprising a conductive layer (10), a photosensitive layer (20), a charge transfer layer (30) and a counter electrode (40), which comprises:
forming, on the photosensitive layer (20), a first layer containing a p-type inorganic compound semiconductor and a thiocyanate, **characterised in that** said thiocyanate being a molten salt.

17. The method for manufacturing a dye-sensitized photoelectric conversion device according to claim 16, further comprising the step of overcoating said first layer with a molten salt.

## Patentansprüche

1. Mit einem Farbstoff sensibilisierte photoelektrische Umwandlungsvorrichtung, umfassend eine leitfähige Schicht (10), eine lichtempfindliche Schicht (20), eine Ladungen transportierende Schicht (30) und eine Gegenelektrode (40), wobei die Ladungen transportierende Schicht (30) eine anorganische Halbleiterverbindung vom p-Typ und ein Thiocyanat umfasst, **dadurch gekennzeichnet, dass** das Thiocyanat ein geschmolzenes Salz ist.

2. Photoelektrische Umwandlungsvorrichtung nach Anspruch 1, wobei die anorganische Halbleiterverbindung vom p-Typ eine Halbleiterverbindung des einwertigen Kupfers ist.

3. Photoelektrische Umwandlungsvorrichtung nach Anspruch 2, wobei die Halbleiterverbindung des einwertigen Kupfers Cul oder CuSNC ist.

4. Photoelektrische Umwandlungsvorrichtung nach einem der Ansprüche 1 bis 3, wobei das Thiocyanat ein substituiertes oder unsubstituiertes Imidazoliumthiocyanat oder ein substituiertes oder unsubstituiertes Pyridiniumthiocyanat ist.

5. Photoelektrische Umwandlungsvorrichtung nach einem der Ansprüche 1 bis 4, wobei das Thiocyanat in einer molaren Menge im Bereich von nicht weniger als 0,2 Mol% bis weniger als 20 Mol% verwendet wird, bezogen auf die Menge der anorganischen Halbleiterverbindung vom p-Typ.

6. Photoelektrische Umwandlungsvorrichtung nach einem der Ansprüche 1 bis 5, wobei die Ladungen transportierende Schicht (30) weiterhin ein geschmolzenes Salz enthält, das nicht dem Thiocyanat entspricht.

7. Photoelektrische Umwandlungsvorrichtung nach Anspruch 6, wobei das geschmolzene Salz, das nicht dem Thiocyanat entspricht, durch die folgende allgemeine Formel (Y-a), (Y-b) oder (Y-c) dargestellt wird: 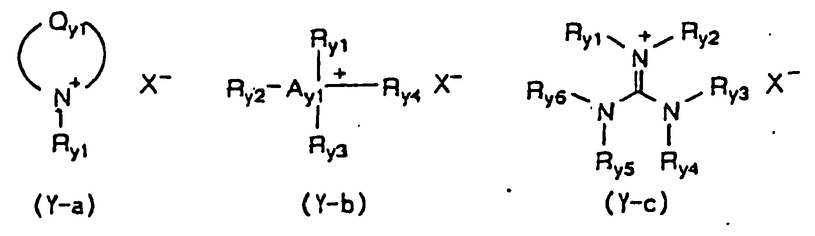 worin Q_{y1} eine Gruppe von Atomen ist, die zusammen mit einem Stickstoffatom ein 5- oder 6-gliedriges aromatisches Kation bilden kann; R_{y1}, R_{y2}, R_{y3}, R_{y4}, R_{y5} und R_{y6} bedeuten jeweils unabhängig voneinander eine substituierte oder unsubstituierte Alkyl- oder Alkenylgruppe mit 1 bis 24 Kohlenstoffatomen; A_{y1} ist ein Stickstoffatom oder ein Phosphoratom; und X⁻ ist ein einwertiges Anion.

8. Photoelektrische Umwandlungsvorrichtung nach Anspruch 7, wobei Q_{y1} in der Formel (Y-a) einen Imidazolring oder einen Pyridinring bildet.

9. Photoelektrische Umwandlungsvorrichtung nach Anspruch 7, wobei X⁻ in der Formel für das geschmolzene Salz ein Bis(pertluoralkylsulfonyl)imidanion ist.

10. Photoelektrische Umwandlungsvorrichtung nach einem der Ansprüche 1 bis 9, wobei die lichtempfindliche Schicht (20) feine, mit einem Farbstoff sensibilisierte Halbleiterteilchen (21) enthält.

11. Photoelektrische Umwandlungsvorrichtung nach Anspruch 10, wobei die feinen Halbleiterteilchen (21) feine Titandioxidteilchen sind.

12. Photoelektrische Umwandlungsvorrichtung nach Anspruch 10 oder 11, wobei der Farbstoff ein Rutheniumkomplexfarbstoff oder ein Polymethinfarbstoff ist.

13. Photoelektrische Umwandlungsvorrichtung nach einem der Ansprüche 1 bis 12, wobei die photoelektrische Umwandlungsvorrichtung eine Grundschicht (60) mit einem oxidischen Halbleiter umfasst, die zwischen der leitfähigen Schicht (10) und der lichtempfindlichen Schicht (20) angeordnet ist.

14. Photoelektrische Zelle, in der eine photoelektrische Umwandlungsvorrichtung nach einem der Ansprüche 1 bis 13 verwendet wird.

15. Solarzellenmodul, in dem eine photoelektrische Umwandlungsvorrichtung nach einem der Ansprüche 1 bis 13 verwendet wird.

16. Verfahren zum Herstellen einer mit einem Farbstoff sensibilisierten photoelektrischen Umwandlungsvorrichtung, umfassend eine leitfähige Schicht (10), eine lichtempfindliche Schicht (20), eine Ladungen transportierende Schicht (30) und eine Gegenelektrode (40), wobei das Verfahren umfasst:
das Aufbringen einer ersten Schicht mit einer anorganischen Halbleiterverbindung vom p-Typ und einem Thiocyanat auf der lichtempfindlichen Schicht (20), **dadurch gekennzeichnet, dass** das Thiocyanat ein geschmolzenes Salz ist.

17. Verfahren zum Herstellen einer mit einem Farbstoff sensibilisierten photoelektrischen Umwandlungsvorrichtung nach Anspruch 16, weiterhin umfassend einen Schritt, bei dem die erste Schicht mit einem geschmolzenen Salz überzogen wird.

## Revendications

1. Dispositif de conversion photoélectrique sensibilisé par le moyen d'une teinte, dont le dispositif comprend une couche conductrice (10), une couche photosensible (20), une couche de transfert de charge (30) et une contre-électrode (40), dans lequel ladite couche de transfert de charge (30) comprend un semi-conducteur composé inorganique de type p et un thiocyanate, **caractérisé en ce que** ledit thiocyanate est un sel fondu.

2. Dispositif de conversion photoélectrique selon la revendication 1, dans lequel ledit semi-conducteur composé inorganique de type p est un semi-conducteur composé contenant du cuivre monovalent.

3. Dispositif de conversion photoélectrique selon la revendication 2, dans lequel ledit semi-conducteur composé contenant du cuivre monovalent est CuI ou CuSNC.

4. Dispositif de conversion photoélectrique selon l'une quelconque des revendications 1 à 3, dans lequel ledit thiocyanate est un thiocyanate d'imidazolium substitué ou non substitué ou un thiocyanate de pyridinium substitué ou non substitué.

5. Dispositif de conversion photoélectrique selon l'une quelconque des revendications 1 à 4, dans lequel ledit thiocyanate est utilisé en une quantité molaire de pas moins de 0,2 % en mole à moins de 20 % en mole sur la base de la quantité du semi-conducteur composé inorganique de type p.

6. Dispositif de conversion photoélectrique selon l'une quelconque des revendications 1 à 5, dans lequel ladite couche de transfert de charge (30) contient en outre un sel fondu autre que le thiocyanate.

7. Dispositif de conversion photoélectrique selon la revendication 6, dans lequel ledit sel fondu autre que le thiocyanate est représenté par la formule générale (Y-a), (Y-b) ou (Y-c) suivante : 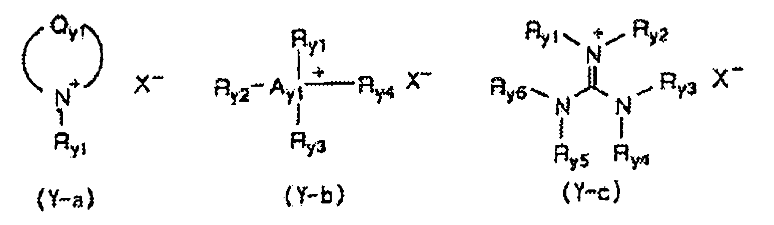 où Q_{y1} représente un groupe atomique qui peut former un cation aromatique à 5 ou 6 chaînons conjointement avec un atome d'azote ; R_{y1}, R_{y2}, R_{y3}, R_{y4}, R_{y5} et R_{y6} représentent chacun indépendamment un groupe alkyle ou alcényle substitué ou non substitué ayant de 1 à 24 atomes de carbone ; A_{y1} représente un atome d'azote ou un atome de phosphore ; et X⁻ représente un anion monovalent.

8. Dispositif de conversion photoélectrique selon la revendication 7, dans lequel Q_{y1} dans la formule (Y-a) est un cycle imidazole ou un cycle pyridine.

9. Dispositif de conversion photoélectrique selon la revendication 7, dans lequel X⁻ dudit sel fondu est un anion bis(perfluoroalkylsulfonyl)imide.

10. Dispositif de conversion photoélectrique selon l'une quelconque des revendications 1 à 9, dans lequel ladite couche photosensible (20) contient de fines particules semi-conductrices (21) sensibilisées avec une teinte.

11. Dispositif de conversion photoélectrique selon la revendication 10, dans lequel lesdites fines particules semi-conductrices (21) sont de fines particules de dioxyde de titane.

12. Dispositif de conversion photoélectrique selon la revendication 10 ou 11, dans lequel ladite teinte est une teinte de complexe de ruthénium ou une teinte de poly(méthine).

13. Dispositif de conversion photoélectrique selon l'une quelconque des revendications 1 à 12, dans lequel le dispositif de conversion photoélectrique comporte une sous-couche (60) comprenant un semi-conducteur d'oxyde entre ladite couche conductrice (10) et ladite couche photosensible (20).

14. Cellule photoélectrique utilisant un dispositif de conversion photoélectrique selon l'une quelconque des revendications 1 à 13.

15. Module de cellule solaire utilisant un dispositif de conversion photoélectrique selon l'une quelconque des revendications 1 à 13.

16. Procédé de fabrication d'un dispositif de conversion photoélectrique sensibilisé par le moyen d'une teinte, dont le dispositif comprend une couche conductrice (10), une couche photosensible (20), une couche de transfert de charge (30) et une contre-électrode (40), qui comprend l'étape consistant à :
former, sur la couche photosensible (20), une première couche contenant un semi-conducteur composé inorganique de type p et un thiocyanate, **caractérisé en ce que** ledit thiocyanate est un sel fondu.

17. Procédé de fabrication d'un dispositif de conversion photoélectrique sensibilisé par le moyen d'une teinte selon la revendication 16, comprenant en outre l'étape de recouvrement de ladite première couche avec un sel fondu.
